# EUROPEAN PATENT SPECIFICATION

(11) **EP 4 593 558 B1**
(45) Date of publication and mention of the grant of the patent: **23.09.2026**
(21) Application number: 24208033.1
(22) Date of filing: 22.10.2024
(51) Int. Cl.: H10F 39/00

(54) **IMAGE SENSOR**
BILDSENSOR
CAPTEUR D'IMAGE

(30) Priority: 26.01.2024 KR 20240012576
(43) Date of publication of application: 30.07.2025
(73) Proprietor: SAMSUNG ELECTRONICS CO., LTD., Yeongtong-gu Suwon-si, Gyeonggi-do 16677 (KR)
(72) Inventor: CHOI, Hyun-Kyu, 16677 Suwon-si, Gyeonggi-do (KR); PARK, Hyeyeon, 16677 Suwon-si, Gyeonggi-do (KR); BAE, Sangin, 16677 Suwon-si, Gyeonggi-do (KR)
(74) Representative: Kuhnen & Wacker Patent- und Rechtsanwaltsbüro PartG mbB

(56) References cited:
- CN-A- 117 423 711
- US-A1- 2012 199 931
- US-A1- 2020 388 643

## Description

### BACKGROUND

### 1. Field

The present disclosure relates generally to an image sensor and a method of fabricating the same, and more particularly, to a complementary metal oxide semiconductor (CMOS) image sensor and a method of fabricating the same.

### 2. Description of Related Art

An image sensor may refer to a semiconductor device that may be configured to convert an optical image to electric signals. With the recent development of the computer and communication industries, there may be an increasing demand for high-performance image sensors in a variety of applications such as, but not limited to, digital cameras, camcorders, personal communication systems, gaming machines, security cameras, micro-cameras for medical applications, robots, or the like. Image sensors may be classified into two types, for example, a charge coupled device (CCD) type and a complementary metal-oxide-semiconductor (CMOS) type. The CMOS-type image sensor may be referred to as CIS. A CIS device may include a plurality of two-dimensionally-arranged pixels. Each of the pixels may include a photodiode (PD) that may convert incident light into an electrical signal. The pixels may be defined by a deep isolation pattern disposed therebetween. A plurality of devices in each pixel may be separated from each other by a device isolation pattern. Document US2012/199931 A1 discloses an image sensor according to the prior-art.

### SUMMARY

One or more example embodiments of the present disclosure provide an image sensor configured to minimize a signal difference between pixels sharing one color filter, and a method of fabricating the same.

Further, one or more example embodiments of the present disclosure provide a highly-sensitive image sensor with increased light-reflection efficiency as recited in independent claims 1 and 10.

Further, one or more example embodiments of the present disclosure provide an image sensor that may be easily integrated, and a method of fabricating the same.

According to an aspect of the present disclosure, an image sensor includes a semiconductor substrate, a color filter group, a micro lens layer at least partially covering the color filter group, and a topmost planarization layer in contact with a top surface of the micro lens layer. The semiconductor substrate includes a first surface, a second surface opposite to the first surface, and a pixel array region. The pixel array region includes a center pixel region and an edge pixel region at least partially enclosing the center pixel region in a plan view. The color filter group includes a center color filter on the center pixel region, an edge color filter on the edge pixel region, and a plurality of color filters. The micro lens layer includes a lens planarization layer in contact with the color filter group and a micro lens on the lens planarization layer. The topmost planarization layer includes an upper recessed portion and a recess center point in each of the center pixel region and the edge pixel region. The upper recessed portion is recessed toward the semiconductor substrate. The recess center point is defined in a lowermost portion of the upper recessed portion. In the center pixel region, a center point of an exposed flat top surface of the lens planarization layer is at least partially vertically overlapped with the recess center point. In the edge pixel region, a center point of the flat top surface is located on a vertical line different from the recess center point.

According to an aspect of the present disclosure, an image sensor includes a semiconductor substrate, a color filter group, a micro lens layer at least partially covering the color filter group, and a topmost planarization layer on the micro lens layer. The semiconductor substrate includes a first surface, a second surface opposite to the first surface, and a pixel array region. The pixel array region includes a center pixel region and an edge pixel region at least partially enclosing the center pixel region in a plan view. The color filter group includes a center color filter on the center pixel region, an edge color filter on the edge pixel region, and a plurality of color filters. The micro lens layer includes a lens planarization layer in contact with the color filter group and a micro lens on the lens planarization layer. The topmost planarization layer includes an upper recessed portion and a recess center point in each of the center pixel region and the edge pixel region. The upper recessed portion is recessed toward the semiconductor substrate. The recess center point is defined in a lowermost portion of the upper recessed portion. The micro lens includes a lens center point defined in a topmost portion of the micro lens. A first vertical distance from the first surface to the recess center point is smaller than a second vertical distance from the first surface to the lens center point.

According to an aspect of the present disclosure, an image sensor includes a semiconductor substrate, a deep device isolation pattern, photoelectric conversion regions, color filter groups on a second surface, a transfer gate on a first surface, a micro lens layer at least partially covering at least one of the color filter groups, and a topmost planarization layer on the micro lens layer. The semiconductor substrate includes a light-receiving region, a light-blocking region, and a pad region and has the first surface and the second surface opposite to the first surface. The deep device isolation pattern is disposed in the semiconductor substrate and configured to define light-receiving pixel regions and light-blocking pixel regions. The photoelectric conversion regions are disposed in the light-receiving region and the light-blocking region of the semiconductor substrate. The light-receiving region includes a center pixel region, and an edge pixel region at least partially enclosing the center pixel region in a plan view. The micro lens layer includes a lens planarization layer in contact with the color filter groups and a micro lens on the lens planarization layer. The topmost planarization layer includes an upper recessed portion and a recess center point. The upper recessed portion is recessed toward the semiconductor substrate. The recess center point is defined in a lowermost portion of the upper recessed portion. The micro lens includes a lens center point in a topmost portion of the micro lens. A first vertical distance from the first surface to the recess center point is smaller than a second vertical distance from the first surface to the lens center point.

Additional aspects may be set forth in part in the description which follows and, in part, may be apparent from the description, and/or may be learned by practice of the presented embodiments.

### BRIEF DESCRIPTION OF THE DRAWINGS

The above and other aspects, features, and advantages of certain embodiments of the present disclosure may be more apparent from the following description taken in conjunction with the accompanying drawings, in which:
FIG. 1 is a block diagram schematically illustrating an image sensor, according to an embodiment;
FIG. 2 is a circuit diagram illustrating an active pixel sensor array of an image sensor, according to an embodiment;
FIG. 3A is a plan view illustrating an image sensor, according to an embodiment;
FIG. 3B is an enlarged plan view illustrating a light-receiving region of FIG. 3A, according to an embodiment;
FIG. 4 is a sectional view taken along a line A-A' of FIG. 3B, according to an embodiment;
FIG. 5 is a sectional view taken along a line B-B' of FIG. 3B, according to an embodiment;
FIG. 6 is a sectional view taken along the line A-A' of FIG. 3B, according to an embodiment;
FIG. 7 is a sectional view taken along the line B-B' of FIG. 3B, according to an embodiment;
FIG. 8 is a sectional view taken along the line A-A' of FIG. 3B, according to an embodiment;
FIG. 9 is a sectional view taken along the line B-B' of FIG. 3B, according to an embodiment;
FIGS. 10A and 11A are sectional views, which are taken along the line A-A' of FIG. 3B, to illustrate a method of fabricating an image sensor, according to an embodiment;
FIGS. 10B and 11B are sectional views, which are taken along the line B-B' of FIG. 3B, to illustrate a method of fabricating an image sensor, according to an embodiment;
FIGS. 12A, 13A, 14A, and 15A are sectional views, which are taken along the line A-A' of FIG. 3B, to illustrate a method of fabricating an image sensor, according to an embodiment;
FIGS. 12B, 13B, 14B, and 15B are sectional views, which are taken along the line B-B' of FIG. 3B, to illustrate a method of fabricating an image sensor, according to an embodiment;
FIG. 16 is a sectional view taken along the line A-A' of FIG. 3B, according to an embodiment;
FIG. 17 is a sectional view taken along the line B-B' of FIG. 3B, according to an embodiment;
FIG. 18 is a sectional view taken along the line A-A' of FIG. 3B, according to an embodiment; and
FIG. 19 is a sectional view taken along the line B-B' of FIG. 3B, according to an embodiment.

### DETAILED DESCRIPTION

The following description with reference to the accompanying drawings is provided to assist in a comprehensive understanding of embodiments of the present disclosure defined by the claims. Various specific details are included to assist in understanding, but these details are considered to be exemplary only.

With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wired), wirelessly, or via a third element.

It is to be understood that when an element or layer is referred to as being "over," "above," "on," "below," "under," "beneath," "connected to" or "coupled to" another element or layer, it may be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

The terms "upper," "middle", "lower", and the like may be replaced with terms, such as "first," "second," third" to be used to describe relative positions of elements. The terms "first," "second," third" may be used to describe various elements but the elements are not limited by the terms and a "first element" may be referred to as a "second element". Alternatively or additionally, the terms "first", "second", "third", and the like may be used to distinguish components from each other and do not limit the present disclosure. For example, the terms "first", "second", "third", and the like may not necessarily involve an order or a numerical meaning of any form.

As used herein, when an element or layer is referred to as "covering", "overlapping", or "surrounding" another element or layer, the element or layer may cover at least a portion of the other element or layer, where the portion may include a fraction of the other element or may include an entirety of the other element. Similarly, when an element or layer is referred to as "penetrating" another element or layer, the element or layer may penetrate at least a portion of the other element or layer, where the portion may include a fraction of the other element or may include an entire dimension (e.g., length, width, depth) of the other element.

Reference throughout the present disclosure to "one embodiment," "an embodiment," "an example embodiment," or similar language may indicate that a particular feature, structure, or characteristic described in connection with the indicated embodiment is included in at least one embodiment of the present solution. Thus, the phrases "in one embodiment", "in an embodiment," "in an example embodiment," and similar language throughout this disclosure may, but do not necessarily, all refer to the same embodiment. The embodiments described herein are example embodiments, and thus, the disclosure is not limited thereto and may be realized in various other forms.

As used herein, each of the terms "Al₂O₃", "HfO", "PTEOS", "SiN", "SiO", "SiO₂", "SiON", and the like may refer to a material made of elements included in each of the terms and is not a chemical formula representing a stoichiometric relationship.

Hereinafter, various embodiments of the present disclosure are described with reference to the accompanying drawings.

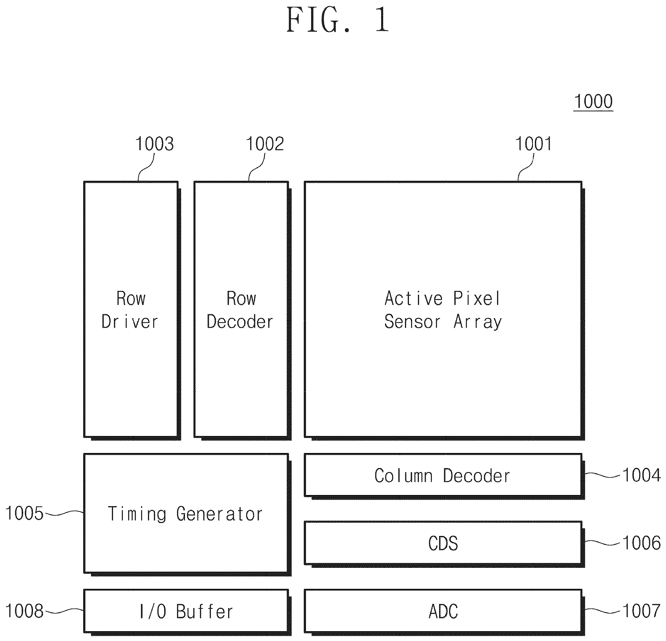

FIG. 1 is a block diagram schematically illustrating an image sensor, according to an embodiment.

Referring to FIG. 1, the image sensor 1000 may include an active pixel sensor array 1001, a row decoder 1002, a row driver 1003, a column decoder 1004, a timing generator 1005, a correlated double sampler (CDS) 1006, an analog-to-digital converter (ADC) 1007, and an input/output (I/O) buffer 1008.

The active pixel sensor array 1001 may include a plurality of unit pixels, which may be two-dimensionally (2D) arranged and may be configured to convert optical signals to electrical signals. The active pixel sensor array 1001 may be driven by a plurality of driving signals, such as, but not limited to, a pixel selection signal, a reset signal, and a charge transfer signal, which may be transmitted from the row driver 1003. In addition, the converted electrical signals may be provided to the correlated double sampler 1006.

The row driver 1003 may be configured to provide the driving signals for driving the plurality of unit pixels to the active pixel sensor array 1001, based on the result decoded by the row decoder 1002. In the case where the unit pixels are arranged in a matrix shape (e.g., in rows and columns), the driving signals may be provided to respective rows.

The timing generator 1005 may be configured to provide timing and control signals to the row decoder 1002 and the column decoder 1004.

The correlated double sampler 1006 may be configured to receive the electric signals generated in the active pixel sensor array 1001 and to perform a holding and sampling operation on the received electric signals. For example, the correlated double sampler 1006 may perform a double sampling operation on a particular noise level and a signal level of the electric signal and may output a difference level corresponding to a difference between the noise and signal levels.

The analog-to-digital converter 1007 may be configured to convert analog signals, which may correspond to the level output from the correlated double sampler 1006, into digital signals, and to output the converted digital signals to the I/O buffer 1008.

The input/output buffer 1008 may be configured to latch the digital signal and to sequentially output the latched digital signals to an image signal processing unit, based on the result decoded by the column decoder 1004.

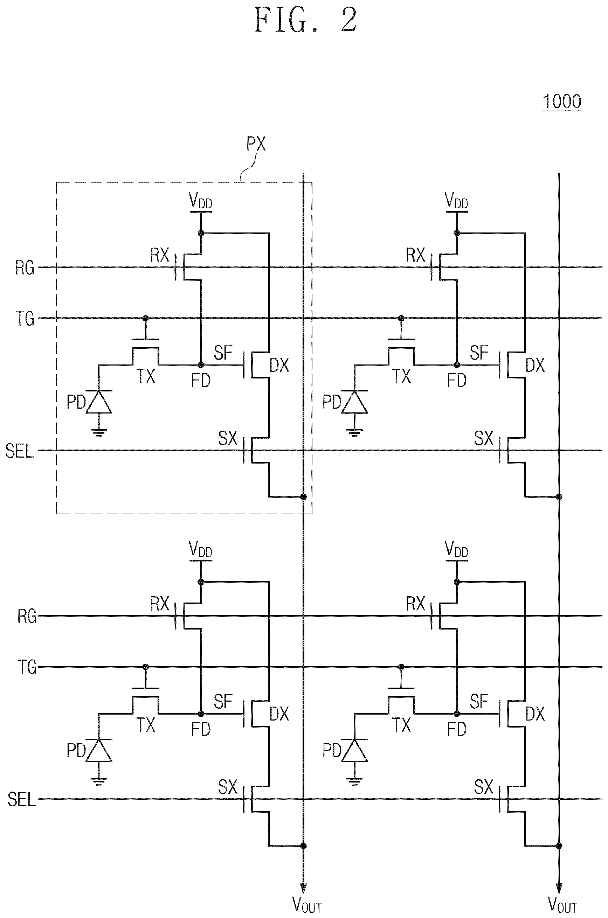

FIG. 2 is a circuit diagram illustrating an active pixel sensor array of an image sensor 1000, according to an embodiment.

Referring to FIGS. 1 and 2, the active pixel sensor array 1001 may include a plurality of pixel regions PX, which may be arranged in a matrix shape. Each pixel region PX may include a transfer transistor TX. Each pixel region PX may further include logic transistors. The logic transistors may include a reset transistor RX, a selection transistor SX, or a source follower transistor DX. The transfer transistor TX may include a transfer gate TG. Each of the pixel regions PX may further include a photoelectric conversion part PD and a floating diffusion region FD. In an embodiment, the logic transistors RX, SX, and DX may be shared by the pixel regions PX.

The photoelectric conversion part PD may be configured to generate photocharges whose amount may be proportional to an amount of light incident from the outside and to store the photocharges. The photoelectric conversion part PD may be and/or may include, but not be limited to, a photodiode, a photo transistor, a photogate, a pinned photodiode, or any combination thereof. The transfer transistor TX may be configured to transfer electric charges, which may be generated in the photoelectric conversion part PD, to the floating diffusion region FD. The floating diffusion region FD may be configured to receive and cumulatively store the electric charges, which may be generated in the photoelectric conversion part PD. The source follower transistor DX may be controlled, based on an amount of photocharges stored in the floating diffusion region FD.

The reset transistor RX may be configured to periodically discharge and/or reset the photocharges accumulated in the floating diffusion region FD. The reset transistor RX may include drain and source electrodes, which may be connected to the floating diffusion region FD and a power voltage VDD, respectively. When the reset transistor RX is turned on, the power voltage VDD, which may be connected to a source electrode of the reset transistor RX, may be applied to the floating diffusion region FD. Thus, if the reset transistor RX is turned on, the electric charges accumulated in the floating diffusion region FD may be discharged. That is, the floating diffusion region FD may be reset.

The source follower transistor DX including a source follower gate electrode SF may be used as a source follower buffer amplifier. The source follower transistor DX may be configured to amplify a variation in electric potential of the floating diffusion region FD and to output the amplified signal to an output line Vout.

The selection transistor SX including a selection gate electrode SEL may be used to select one of the rows of the pixel regions PX during reading operations. When the selection transistor SX is turned on, the power voltage VDD may be applied to a drain electrode of the source follower transistor DX.

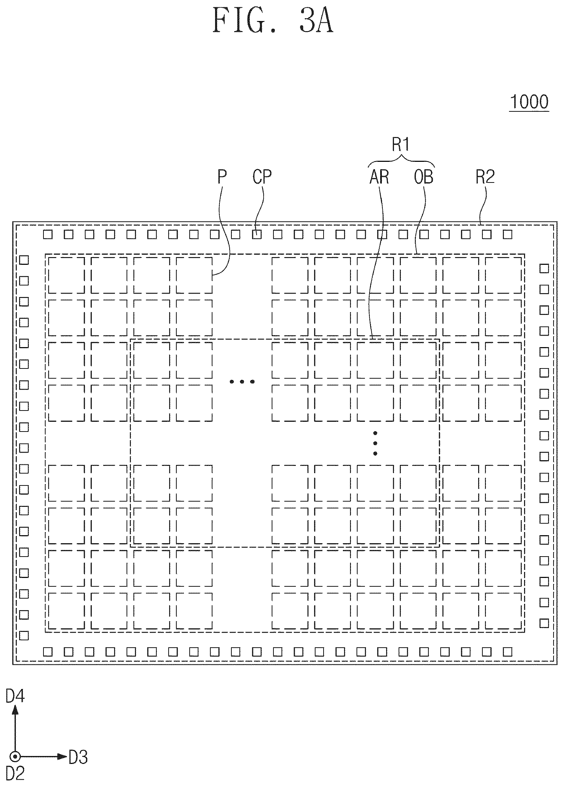

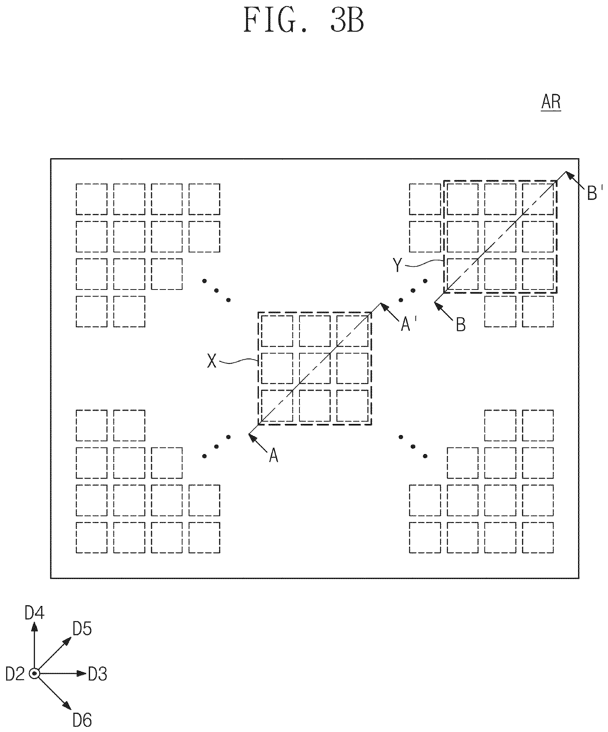

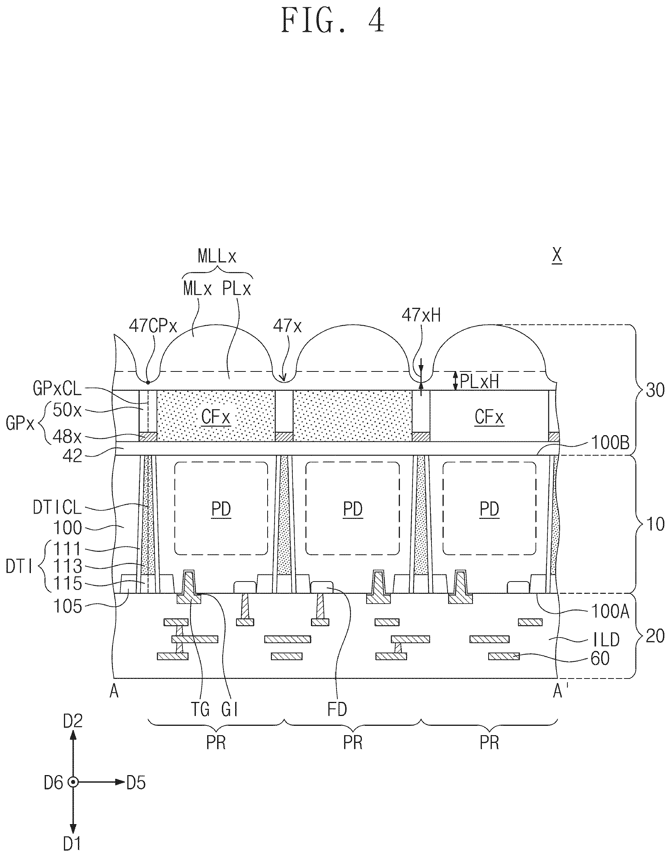

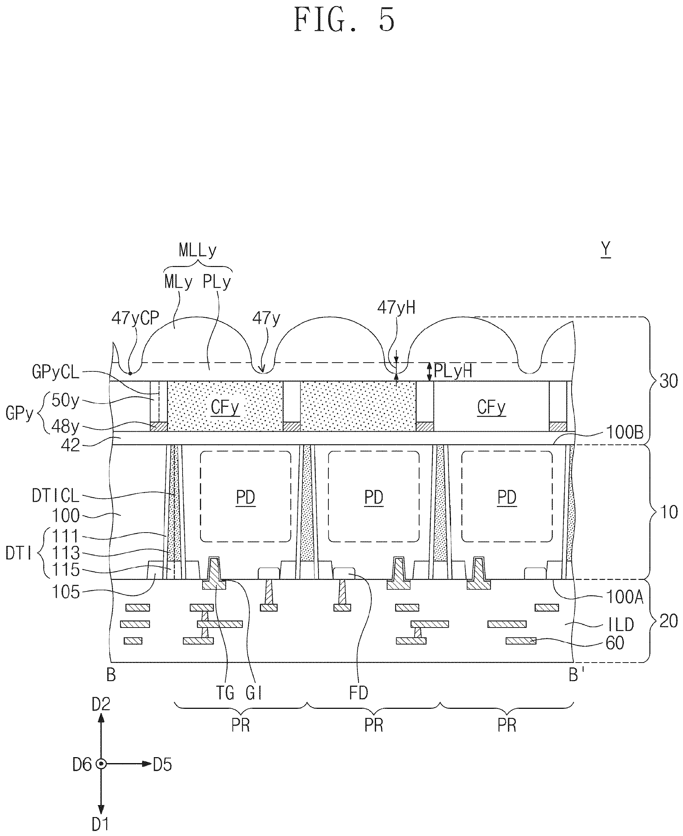

FIG. 3A is a plan view illustrating an image sensor, according to an embodiment. FIG. 3B is an enlarged plan view illustrating a light-receiving region of FIG. 3A, according to an embodiment. FIG. 4 is a sectional view taken along a line A-A' of FIG. 3B, according to an embodiment. FIG. 5 is a sectional view taken along a line B-B' of FIG. 3B, according to an embodiment.

The image sensor 1000 may include a photoelectric conversion layer 10, a pixel circuit layer 20, and an optically-transparent layer 30, when viewed in a vertical section. The photoelectric conversion layer 10 may be disposed between the pixel circuit layer 20 and the optically-transparent layer 30, when viewed in a vertical section. The photoelectric conversion layer 10 may be configured to convert light, which may be incident from the outside, to electrical signals.

The photoelectric conversion layer 10 may include a device isolation layer 105, a deep device isolation pattern DTI, a photoelectric conversion region PD, and the floating diffusion region FD.

Referring to FIGS. 3A and 3B, the image sensor may include a pixel array region R1 and a pad region R2.

The pixel array region R1 may include a plurality of pixels P, which may be two-dimensionally arranged in a third direction D3 and a fourth direction D4 that may not be parallel to each other. Each of the pixels P may include a photoelectric conversion device and at least one readout device. Each of the pixels P of the pixel array region R1 may be configured to output electrical signals, which may be generated by incident light.

The pixel array region R1 may include a light-receiving region AR and a light-blocking region OB. When viewed in a plan view, the light-blocking region OB may be configured to enclose the light-receiving region AR. That is, the light-blocking region OB may be disposed to enclose the light-receiving region AR in four (4) different directions (e.g., up, down, left, and right directions), when viewed in a plan view. In an embodiment, reference pixels P, to which light may not be incident, may be provided in the light-blocking region OB. In this case, by comparing a charge amount, which may be obtained from the unit pixel P in the light-receiving region AR, with a reference amount of charges generated in the reference pixels P, a magnitude of an electrical signal generated by the unit pixel P may be calculated.

The light-receiving region AR of the pixel array region R1 may include a center pixel region X, in which a plurality of pixels may be provided, and an edge pixel region Y, which may be provided to enclose the center pixel region X in a plan view. The edge pixel region Y may be disposed to enclose the center pixel region X in four (4) different directions (e.g., up, down, left, and right directions), when viewed in a plan view. In such an embodiment, light rays may be incident into the edge pixel region Y and the center pixel region X, respectively, with different angles.

Color filters and micro lenses may be disposed on the pixel array region R1.

The color filters may be disposed on the pixel array region R1 to cover the reference pixels P, respectively. The color filters may be arranged in n rows and n columns to form a plurality of color filter groups, where n is a positive integer greater than zero (0).

The color filter groups may include a center color filter group on the center pixel region X and an edge color filter group on the edge pixel region Y. The center color filter group may include a center color filter CFx, and the edge color filter group may include an edge color filter CFy.

The color filters may include a red color filter, a green color filter, and a blue color filters. The red, green, and blue color filters may be configured to selectively pass the incident light.

The micro lenses may be configured to condense the incident light that may be incident from the outside. When viewed in a plan view, the micro lenses may be two-dimensionally (2D) arranged in third and fourth directions D3 and D4, which may not be parallel to each other.

In an embodiment, each of the micro lenses may be provided to cover one of the color filter groups. In an embodiment, each of the micro lenses may cover a color filter group, in which the color filters are arranged in two (2) rows and two (2) columns. The color filters and the micro lenses are further described with reference to FIGS. 4 to 9.

The image sensor 1000 may include a substrate 100. For example, the substrate 100 may be and/or may include a single-crystalline silicon wafer, a silicon epitaxial layer, or a silicon-on-insulator (SOI) substrate. In an embodiment, the substrate 100 may be doped with impurities of a first conductivity type (e.g., p-type). The substrate 100 may include a first surface 100A and a second surface 100B, which may be opposite to each other. An outward direction, which may be normal to the first surface 100A, may be referred to as a first direction D1, and an outward direction, which may be normal to the second surface 100B, may be referred to as a second direction D2. The first direction D1 and the second direction D2 may be opposite to each other.

In each of pixel regions PR, the device isolation layer 105 may be provided adjacent to the first surface 100A of the substrate 100. The device isolation layer 105 may be provided in a device isolation trench, which may be formed by recessing the first surface 100A of the substrate 100. The device isolation layer 105 may include an insulating material. The device isolation layer 105 may define an active portion in the first surface 100A of the substrate 100. For example, the device isolation layer 105 may define first and second active portions in the substrate 100. The first and second active portions may be spaced apart from each other in each of the pixel regions PR and may have different sizes from each other.

The deep device isolation pattern DTI may be placed in the substrate 100. The pixel regions may be separated from each other by the deep device isolation pattern DTI. The deep device isolation pattern DTI may be provided between the pixel regions PR to penetrate the substrate 100 in the second direction D2.

The deep device isolation pattern DTI may be disposed in a trench, which may be extended from the first surface 100A toward the second surface 100B. When viewed in a plan view, the deep device isolation pattern DTI may have a mesh and/or net shape, which may be formed by line-shaped patterns extended in the third and fourth directions D3 and D4.

The deep device isolation pattern DTI may be extended from the first surface 100A into the substrate 100 and may be interposed between the pixel regions PR. The deep device isolation pattern DTI may define a plurality of photoelectric conversion parts. The deep device isolation pattern DTI may be provided to penetrate the substrate 100 in a direction from the first surface 100A toward the second surface 100B. The deep device isolation pattern DTI may be provided to penetrate a portion of the device isolation layer 105.

The deep device isolation pattern DTI may have an upper width at a level of the first surface 100A of the substrate 100 and may have a lower width at a level of the second surface 100B of the substrate 100. The lower width may be smaller than the upper width. For example, the width of the deep device isolation pattern DTI may gradually decrease as a distance from the first surface 100A of the substrate 100 increases in a direction toward the second surface 100B. The deep device isolation pattern DTI may have a length in the third direction D3. The length of the deep device isolation pattern DTI may be substantially similar and/or equal to a vertical thickness of the substrate 100.

A line passing through the center of the deep device isolation pattern DTI may be referred to as a deep device isolation center line DTICL. That is, a vertical line, which passes through the deep device isolation pattern DTI and is spaced apart from two opposite ends of the deep device isolation pattern DTI by the same distance, may be referred to as the deep device isolation center line DTICL.

The deep device isolation pattern DTI may include a liner insulating pattern 111, a semiconductor pattern 113, and a capping insulating pattern 115.

The semiconductor pattern 113 may be provided to penetrate at least a portion of the substrate 100 in the third direction D3. The liner insulating pattern 111 may be provided between the semiconductor pattern 113 and the substrate 100. The capping insulating pattern 115 may be provided on the semiconductor pattern 113.

A bottom surface of the semiconductor pattern 113 may be located at substantially similar and/or the same level as the second surface 100B of the substrate 100. A top surface of the semiconductor pattern 113 may be in direct contact with a bottom surface of the capping insulating pattern 115. An air gap and/or a void may be present in the semiconductor pattern 113. In an embodiment, the semiconductor pattern 113 may be formed of and/or include a polysilicon.

The bottom surface of the capping insulating pattern 115 may be located at a level that is lower than or equal to a bottom surface of the device isolation layer 105. The bottom surface of the capping insulating pattern 115 may have a rounded shape. A top surface of the capping insulating pattern 115 may be located at a substantially similar and/or the same level as a top surface of the device isolation layer 105 (e.g., the first surface 100A of the substrate 100). The liner insulating pattern 111 may cover a side surface of the semiconductor pattern 113 and a side surface of the capping insulating pattern 115 conformally (e.g., with a substantially constant and/or the same thickness). In an embodiment, the liner insulating pattern 111 and the capping insulating pattern 115 may be formed of and/or include at least one of silicon oxide (SiO), silicon oxynitride (SiON), or silicon nitride (SiN).

The photoelectric conversion regions PD may be provided in the semiconductor substrate 100 and in each of the pixel regions PR. The photoelectric conversion regions PD may generate photocharges in proportion to an intensity of an incident light. The photoelectric conversion regions PD may be formed by injecting impurities, which may be of a second conductivity type different from the substrate 100, into the substrate 100. The photoelectric conversion region PD of the second conductivity type and the substrate 100 of the first conductivity type may form a PN junction serving as a photodiode. In an embodiment, each of the photoelectric conversion regions PD may be provided to have a difference in doping concentration between portions adjacent to the first and second surfaces 100A and 100B, thereby having a non-vanishing gradient in potential between the first and second surfaces 100A and 100B of the semiconductor substrate 100. For example, the photoelectric conversion regions PD may include a plurality of impurity regions, which may be vertically stacked.

The pixel circuit layer 20 may be disposed on the first surface 100A of the substrate 100. The pixel circuit layer 20 may include pixel circuits (e.g., metal oxide semiconductor (MOS) transistors), which may be electrically connected to the photoelectric conversion regions PD. For example, the pixel circuit layer 20 may include the reset transistor RX, the selection transistor SX, a dual conversion gain transistor , and the source follower transistor SF, which may be the pixel transistors described with reference to FIG. 2.

In each pixel region PX, the transfer gate TG may be provided on the first surface 100A of the substrate 100. In an embodiment, a portion of the transfer gate TG may be buried in the substrate 100. The transfer gate TG may be of a vertical type. In an embodiment, the transfer gate TG may be a planar or flat-shaped pattern, which may be provided on the first surface 100A of the substrate 100.

A gate insulating pattern GI may be interposed between the transfer gate TG and the substrate 100. The floating diffusion region FD may be provided in a portion of the substrate 100 adjacent to the transfer gate TG. The floating diffusion region FD may be provided in a first active portion located at a side of the transfer gate electrode TG. The floating diffusion region FD may be formed by injecting impurities into the semiconductor substrate 100 and may have a conductivity type different from that of the semiconductor substrate 100. For example, the floating diffusion region FD may be an impurity region of the second conductivity type.

In an embodiment, light may be incident into the substrate 100 through the second surface 100B of the substrate 100. Electron-hole pairs may be generated in the PN junction by the incident light. The electrons, which may be generated by this process, may be transferred to the photoelectric conversion part PD. The electrons may be transferred to the floating diffusion region FD by applying a voltage to the transfer gate TG.

An interlayer insulating layer ILD may be provided on the first surface 100A of the substrate 100 to cover the first surface 100A. The interlayer insulating layer ILD may be a composite layer including, but not being limited to, at least one of silicon oxide (SiO), silicon nitride (SiN), silicon oxynitride (SiON), or porous low-k dielectric materials. Interconnection lines 60 may be provided in the interlayer insulating layer ILD. In an embodiment, a floating diffusion region may be connected to the interconnection lines 60. The interconnection lines 60 and the interlayer insulating layer ILD may constitute the pixel circuit layer 20. The pixel circuit layer 20 may be provided on the first surface 100A of the substrate 100.

The optically-transparent layer 30 may be disposed on the second surface 100B of the substrate 100. The optically-transparent layer 30 may include an anti-reflection layer 42, a grid structure (e.g., a first grid structure GPx or a second grid structure GPy), color filters (e.g., the center color filter CFx and the edge color filter CFy), and a micro lens layer (e.g., a first micro lens layer MLLx or a second micro lens layer MLLy). The optically-transparent layer 30 may be configured to perform an operation of focusing and/or filtering light, which may be incident from the outside, and to provide the light to the photoelectric conversion layer 10.

The anti-reflection layer 42 may be disposed on the deep device isolation pattern DTI. The first anti-reflection layer 42 may be provided on the second surface 100B of the substrate 100 to cover the second surface 100B. The anti-reflection layer 42 may include an oxide material, for example. In an embodiment, the anti-reflection layer 42 may be formed of or include at least one of Al₂O₃, HfO, SiO₂, phosphorous tetraethyl orthosilicate (PTEOS).

The first or second grid structure GPx or GPy may be disposed on the anti-reflection layer 42. The first or second grid structure GPx or GPy may be interposed between the color filters. The first or second grid structure GPx or GPy may include a light-blocking pattern (e.g., a first light-blocking pattern 48x or a second light-blocking pattern 48y) and a low-refractive pattern (e.g., a first low-refractive pattern 50x or a second low-refractive pattern 50y). The first or second low-refractive pattern 50x or 50y may be disposed on the first or second light-blocking pattern 48x or 48y.

A line passing through the center of the first or second grid structure GPx or GPy may be referred to as a grid center line (e.g., a first grid center line GPxCL or a second grid center line GPyCL). That is, a vertical line, which passes through the first or second grid structure GPx or GPy and is spaced apart from two opposite ends of the first or second grid structure GPx or GPy by the same distance, may be referred to as the first or second grid center line GPxCL or GPyCL.

In an embodiment, the first or second light-blocking pattern 48x or 48y and the first or second low-refractive pattern 50x or 50y may be overlapped with the deep device isolation pattern DTI and may have a grid shape, when viewed in a plan view.

In an embodiment, the first or second light-blocking pattern 48x or 48y and the first or second low-refractive pattern 50x or 50y may not be overlapped with the deep device isolation pattern DTI and may have a grid shape, when viewed in a plan view. In an embodiment, the first or second light-blocking pattern 48x or 48y may include titanium (Ti), for example. The first and second low-refractive patterns 50x and 50y may have a substantially similar and/or the same thickness and may be formed of a substantially similar and/or the same organic material. The first or second low-refractive pattern 50x or 50y may have a refractive index lower than the color filters. The first or second light-blocking pattern 48x or 48y and the first or second low-refractive pattern 50x or 50y may prevent a cross-talk issue from occurring between adjacent ones of the pixel regions PR.

The center or edge color filter CFx or CFy may be disposed on the anti-reflection layer 42. The center or edge color filter CFx or CFy may constitute a color filter group. That is, the color filter group may include the center color filter CFx on a center pixel region and the edge color filter CFy on an edge pixel region.

The first or second micro lens layer MLLx or MLLy may be disposed on the center or edge color filter CFx or CFy and the first or second grid structure GPx or GPy. The first or second micro lens layer MLLx or MLLy may be disposed to cover the color filter group.

The first or second micro lens layer MLLx or MLLy may include a lens planarization layer (e.g., a first lens planarization layer PLx or a second lens planarization layer Ply) in contact with the color filter group and a micro lens (e.g., a first micro lens MLx or a second micro lens MLy) on the first or second lens planarization layer PLx or PLy. The first or second lens planarization layer PLx or PLy may include a recessed lens portion (e.g., a first recessed lens portion 47x or a second recessed lens portion 47y), which may be recessed toward the substrate 100. The first or second micro lenses MLx or MLy may be spaced apart from each other.

In an embodiment, each of the first or second micro lenses MLx or MLy may be overlapped with a corresponding one of the photoelectric conversion parts PD. In an embodiment, each of the first or second micro lenses MLx or MLy may be overlapped with the photoelectric conversion parts PD. For example, each of the first or second micro lenses MLx or MLy may overlapped with four (4) photoelectric conversion parts PD, which may be arranged in a clockwise direction.

The image sensor 1000 in the center and edge pixel regions X and Y are further described with reference to FIGS. 4 and 5.

Referring to FIG. 4, the image sensor 1000 in the center pixel region X is further described below. In an embodiment, the center pixel region X may be referred to as a pixel region in a center region of the substrate 100, when viewed in a plan view. The center pixel region X may include a center color filter group on the center pixel region X. The center color filter group may include a plurality of center color filters CFx. The center pixel region X may include the center color filters CFx and the photoelectric conversion parts PD corresponding thereto.

In the center pixel region X, the photoelectric conversion part PD and the center color filter CFx may be shifted from each other. The center color filter CFx may be provided such that the center color filter CFx may be fully overlapped with the photoelectric conversion part PD. For example, in the center pixel region X, the photoelectric conversion part PD may be provided between adjacent ones of the deep device isolation patterns DTI, and the center color filter CFx may be provided between adjacent ones of the first grid structure GPx, which may be overlapped with the deep device isolation pattern DTI. In the center pixel region X, the first grid structure GPx may include the first light-blocking pattern 48x and the first low-refractive pattern 50x.

In the center pixel region X, the first micro lens layer MLLx may be provided on the center color filter CFx.

In the center pixel region X, the first micro lens MLx may be provided on the first lens planarization layer PLx. There may be no interface between the first lens planarization layer PLx and the first micro lens MLx. The first lens planarization layer PLx and the first micro lens MLx may be connected to form a single object physically.

In the center pixel region X, the first lens planarization layer PLx of the first micro lens layer MLLx may include the first recessed lens portion 47x. The first recessed lens portion 47x may be referred to as a recess and/or a hole, which may be formed by recessing the first lens planarization layer PLx toward the substrate 100. The first recessed lens portion 47x may be disposed between the first micro lenses MLx, which may be closely spaced apart from each other in a plan view.

In an embodiment, the first recessed lens portion 47x may be shaped like a partially-cut ellipse. In such a case, an inner surface of the first recessed lens portion 47x may have a curved surface. A curvature of the first micro lens MLx may be different from a curvature of the first recessed lens portion 47x. In an embodiment, the curvature of the first micro lens MLx may be smaller than the curvature of the first recessed lens portion 47x.

In an embodiment, the first recessed lens portion 47x may have a uniformly decreasing width as a distance to the substrate 100 decreases. In such a case, the inner surface of the first recessed lens portion 47x may be a flat surface.

A first recessed lens center point 47CPx may be provided in the lowermost portion of a recessed portion of the first recessed lens portion 47x. A vertical distance from the first recessed lens center point 47CPx to a top surface of the first lens planarization layer PLx may be referred to as a first recessed lens height 47xH. A first height PLxH of the first lens planarization layer PLx may be larger than the first recessed lens height 47xH. The first recessed lens portion 47x may be spaced apart from the first grid structure GPx and the center color filter CFx. The first lens planarization layer PLx may be in contact with the first grid structure GPx and the center color filter CFx.

In the center pixel region X, the first recessed lens portion 47x, the first grid structure GPx, and the deep device isolation pattern DTI may be overlapped with each other.

In the center pixel region X, the first grid center line GPxCL of the first grid structure GPx, the first recessed lens center point 47CPx, and the device isolation center line DTICL of the deep device isolation pattern DTI may be located on the same vertical line. In the center pixel region X, the first grid center line GPxCL of the first grid structure GPx, the first recessed lens center point 47CPx, and the device isolation center line DTICL of the deep device isolation pattern DTI may be overlapped with each other.

Referring to FIG. 5, the image sensor 1000 in the edge pixel region Y is further described below. The edge pixel region Y may be referred to as a region enclosing the center pixel region X of the substrate, when viewed in a plan view. The edge pixel region Y may include an edge color filter group on the edge pixel region Y. The edge color filter group may include a plurality of edge color filters CFy. The edge pixel region Y may include the edge color filters CFy and the photoelectric conversion parts PD corresponding thereto.

In the edge pixel region Y, the photoelectric conversion part PD and the edge color filters CFy may be shifted from each other. The edge color filter CFy may be provided to be partially overlapped with the photoelectric conversion part PD. For example, in the edge pixel region Y, the photoelectric conversion part PD may be provided between adjacent ones of the deep device isolation pattern DTI, and the center color filter CFy may be provided between adjacent ones of the second grid structure GPy, which may be overlapped with the deep device isolation pattern DTI. In the edge pixel region Y, the second grid structure GPy may include the second light-blocking pattern 48y and the second low-refractive pattern 50y.

In the edge pixel region Y, the edge color filter CFy may be overlapped with the deep device isolation pattern DTI and the photoelectric conversion part PD. The photoelectric conversion part PD may be overlapped with the second grid structure GPy.

In the edge pixel region Y, the second micro lens layer MLLy may be provided on the edge color filter CFy.

In the edge pixel region Y, the second micro lens MLy may be provided on the second lens planarization layer PLy. There may be no interface between the second lens planarization layer PLy and the second micro lens MLy. The second lens planarization layer PLy and the second micro lens MLy may be connected to form a single object physically.

In the edge pixel region Y, the second lens planarization layer PLy of the second micro lens layer MLLy may include the second recessed lens portion 47y. The second recessed lens portion 47y may be referred to as a recess and/or a hole, which may be formed by recessing the second lens planarization layer PLy toward the substrate 100. The second recessed lens portion 47y may be disposed between the second micro lenses MLy, which may be closely spaced apart from each other in a plan view.

In an embodiment, the second recessed lens portion 47y may have an elliptical shape. In such a case, an inner surface of the second recessed lens portion 47y may have a curved surface. A curvature of the second micro lens MLy may be different from a curvature of the second recessed lens portion 47y. In an embodiment, the curvature of the second micro lens MLy may be smaller than the curvature of the second recessed lens portion 47y.

In an embodiment, the second recessed lens portion 47y may have a uniformly decreasing width as a distance to the substrate 100 decreases. In such a case, the inner surface of the second recessed lens portion 47y may have a flat surface.

In the edge pixel region Y, a second recessed lens center point 47yCP may be provided in the lowermost portion of a recessed portion of the second recessed lens portion 47y. A vertical distance from the second recessed lens center point 47yCP to a top surface of the second lens planarization layer PLy may be referred to as a second recessed lens height 47yH. The second height PLyH of the second lens planarization layer Ply may be larger than the second recessed lens height 47yH. The second recessed lens portion 47y may be spaced apart from the second grid structure GPy and the edge color filter CFy. The second lens planarization layer PLy may be in contact with the second grid structure GPy and the edge color filter CFy.

In the edge pixel region Y, the second recessed lens portion 47y may not be overlapped with the deep device isolation pattern DTI. The second recessed lens portion 47y may be overlapped with the edge color filter CFy. The recessed second lens portion 47y may be overlapped with the photoelectric conversion part PD. The second recessed lens portion 47y may not be aligned with the second grid structure GPy.

In the edge pixel region Y, the second grid structure GPy may be overlapped with the photoelectric conversion part PD. The second grid structure GPy may be overlapped with the second micro lens MLy. The second grid structure GPy may not be aligned with the deep device isolation pattern DTI.

In the edge pixel region Y, the second grid center line GPyCL of the second grid structure GPy and the device isolation center line DTICL of the deep device isolation pattern DTI may not be located on different vertical lines from each other. The second grid center line GPyCL and the second recessed lens center point 47yCP may not be located on different vertical lines from each other. In the edge pixel region Y, the second grid center line GPyCL of the second grid structure GPy, the second recessed lens center point 47yCP, and the device isolation center line DTICL of the deep device isolation pattern DTI may not be overlapped with each other. The second recessed lens center point 47yCP may be overlapped with the edge color filter CFy and the photoelectric conversion part PD. The device isolation center line DTICL may be overlapped with the edge color filter CFy. The second grid center line GPyCL may be overlapped with the second micro lens MLy and the photoelectric conversion part PD.

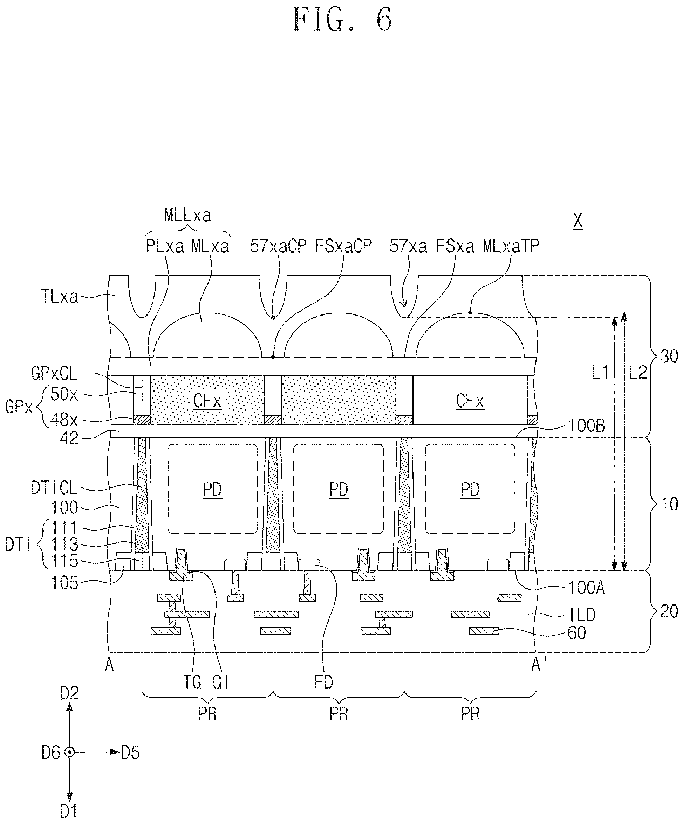

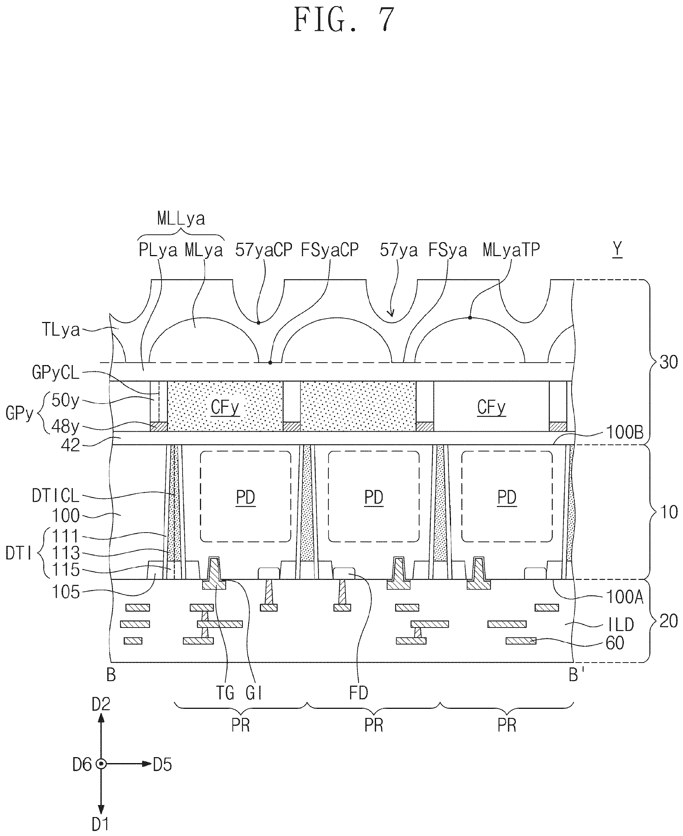

FIG. 6 is a sectional view taken along the line A-A' of FIG. 3B, according to an embodiment. FIG. 7 is a sectional view taken along the line B-B' of FIG. 3B, according to an embodiment. Regions X and Y of FIGS. 6 and 7 may include and/or may be similar in many respects to the regions X and Y respectively described above with reference to FIGS. 4 and 5, and may include additional features not mentioned above. Consequently, repeated descriptions of the regions X and Y described above with reference to FIGS. 4 and 5 may be omitted for the sake of brevity.

Referring to FIGS. 6 and 7, the image sensor 1000 may be provided.

When viewed in a vertical section, the image sensor may 1000 include a photoelectric conversion layer 10, a pixel circuit layer 20, and an optically-transparent layer 30, when viewed in a vertical section.

The photoelectric conversion layer 10 may include the device isolation layer 105, the deep device isolation pattern DTI, the photoelectric conversion region PD, and the floating diffusion region FD.

The pixel circuit layer 20 may include the interconnection lines 60 and the interlayer insulating layer ILD.

The optically-transparent layer 30 may include the anti-reflection layer 42, a grid structure (e.g., a first grid structure GPxa or a second grid structure GPya), the center or edge color filters CFx or CFy, a micro lens layer (e.g., a first micro lens layer MLLxa or a second micro lens layer MLLya), and a topmost planarization layer (e.g., a first topmost planarization layer TLxa or a second topmost planarization layer TLya) on the first or second micro lens layer MLLxa or MLLya. The first or second topmost planarization layer TLxa or TLya may include an upper recessed portion (e.g., a first upper recessed portion 57xa or a second upper recessed portion 57ya), which is recessed toward the substrate.

A refractive index of the first or second topmost planarization layer TLxa or TLya may be lower than a refractive index of the first or second micro lens layer MLLxa or MLLya and may be higher than a refractive index of the air.

Each of micro lenses first or second MLxa or MLya may correspond to one of the photoelectric conversion parts PD.

FIG. 6 illustrates a detailed structure of the image sensor in the center pixel region X. The first micro lens layer MLLxa may include a first lens planarization layer PLxa in contact with the color filter group and the first micro lens MLxa on the first lens planarization layer PLxa. The first lens planarization layer PLxa may have a first flat top surface FSxa that may be exposed. In an embodiment, a first plurality of micro lenses MLxa may be spaced apart from each other. The first flat top surface FSxa of the first lens planarization layer PLxa may be provided between the first plurality of micro lenses MLxa, which may be spaced apart from each other. The first flat top surface FSxa of the first lens planarization layer PLxa may have a flat surface.

The first micro lens MLxa may have a first lens center point MLxaTP, which may be provided at the topmost portion of first the micro lens MLxa. When viewed in a plan view, the first lens center point MLxaTP may be located at a center of the first micro lens MLxa.

A center point of the first flat top surface FSxa of the lens planarization layer PLxa may be referred to as a first center point FSxaCP of the first flat top surface FSxa. That is, a point of the first flat top surface FSxa, which may be spaced apart from two opposite ends of the first flat top surface FSxa by the same distance, may be referred to as the first center point FSxaCP of the first flat top surface FSxa.

The first topmost planarization layer TLxa may be provided on the first micro lens layer MLLxa. The first topmost planarization layer TLxa may be provided to be in contact with the entirety of the first micro lens layer MLLxa. The topmost planarization layer TLxa may be in contact with the entire top surface of the micro lens layer MLLxa. Top surfaces of the first micro lenses MLxa may be in direct contact with the first topmost planarization layer TLxa.

The first topmost planarization layer TLxa may include the upper recessed portion 57xa that may be referred to as a recess and/or a hole, which may be formed by recessing a portion of the first topmost planarization layer TLxa toward the substrate 100. The first upper recessed portion 57xa may have a first recess center point 57xaCP, which may be provided at the lowermost portion of the first upper recessed portion 57xa. The first recess center point 57xaCP may be referred to as a point of the first upper recessed portion 57xa that may be closest to the substrate 100.

The first upper recessed portion 57xa may be shaped like a portion of an ellipse. The first upper recessed portion 57xa may have a curved shape, which may be recessed toward the substrate 100. An inner surface of the first upper recessed portion 57xa may have a curved surface. The inner surface of the first upper recessed portion 57xa may include a curvedly rounded portion. A curvature of the first micro lens MLx may be different from a curvature of the first upper recessed portion 57xa. In an embodiment, the curvature of the first micro lens MLx may be smaller than the curvature of the first upper recessed portion 57xa.

A vertical distance from the first surface 100A of the substrate 100 to the first recess center point 57xaCP of the first upper recessed portion 57xa may be referred to as a first distance L1. A vertical distance from the first surface 100A of the substrate 100 to the first lens center point MLxaTP of the first micro lens MLxa may be referred to as a second distance L2. The first distance L1 may be smaller than the second distance L2. That is, the vertical distance from the first surface 100A of the substrate 100 to the first recess center point 57xaCP of the first upper recessed portion 57xa may be smaller than the vertical distance from the first surface 100A of the substrate 100 to the first lens center point MLxaTP of the first micro lens MLxa. The first lens center point MLxaTP of the first micro lens MLxa may be disposed between the first recess center points 57xaCP, which may be closely spaced apart from each other in a plan view. The first separated recess center points 57xaCP may be spaced apart from the first lens center point MLxaTP by a substantially similar and/or the same distance.

In the center pixel region X, the first upper recessed portion 57xa, the first flat top surface FSxa, and the deep device isolation pattern DTI may be overlapped with each other. The first recess center point 57xaCP of the first upper recessed portion 57xa, the first center point FSxaCP of the flat top first surface FSxa, and the device isolation center line DTICL of the deep device isolation pattern DTI may be located on the same vertical line. When viewed in a plan view, the first micro lens MLxa may be disposed between the first recess center points 57xaCP, which may be closely spaced apart from each other. The first grid structure GPx may be overlapped with the first flat top surface FSxa of the first lens planarization layer PLxa and the first upper recessed portion 57xa. The first lens center point MLxaTP may be overlapped with the center color filter CFx.

FIG. 7 illustrates a detailed structure of the image sensor 1000 in the edge pixel region Y.

In the edge pixel region Y, the photoelectric conversion part PD and the edge color filters CFy may be shifted from each other. The edge color filters CFy and the second micro lens layer MLLya may be shifted from each other. The second micro lens layer MLLya and the second topmost planarization layer TLya may be shifted from each other.

In the edge pixel region Y, the second upper recessed portion 57ya, a second flat top surface FSya, and the deep device isolation pattern DTI may be misaligned with each other. A second recess center point 57yaCP of the second upper recessed portion 57ya, a second center point FSyaCP of the first flat top surface FSxa, and the device isolation center line DTICL of the deep device isolation pattern DTI may be located on different vertical lines from each other.

In the edge pixel region Y, the second upper recessed portion 57ya, the second micro lens MLya, the edge color filter CFy, and the photoelectric conversion part PD may be overlapped with each other. The second grid structure GPy may be overlapped with the photoelectric conversion part PD and the second micro lens MLya. The deep device isolation pattern DTI may be overlapped with the edge color filter CFy and the second micro lens MLya.

A curvature of the first upper recessed portion 57xa in the center pixel region X may be different from a curvature of the second upper recessed portion 57ya in the edge pixel region Y. For example, the curvature of the first upper recessed portion 57xa in the center pixel region X may be greater than the curvature of the second upper recessed portion 57ya in the edge pixel region Y. A width of the topmost portion of the first upper recessed portion 57xa in the center pixel region X may be smaller than a width of the topmost portion of the second upper recessed portion 57ya in the edge pixel region Y.

A second lens center point MLyaTP of the second micro lens MLya may be disposed between the second recess center points 57yaCP, which may be closely spaced apart from each other in a plan view. The separated second recess center points 57yaCP may be spaced apart from the second lens center point MLyaTP by different distances. The second lens center point MLyaTP may be overlapped with the edge color filter CFy.

Since the first or second topmost planarization layer TLxa or TLya includes the first or second upper recessed portion 57xa or 57ya, light, which may pass through the optically-transparent layer 30 and may be incident into the photoelectric conversion layer 10, may be refracted, and as such, it may be possible to suppress a cross-talk issue.

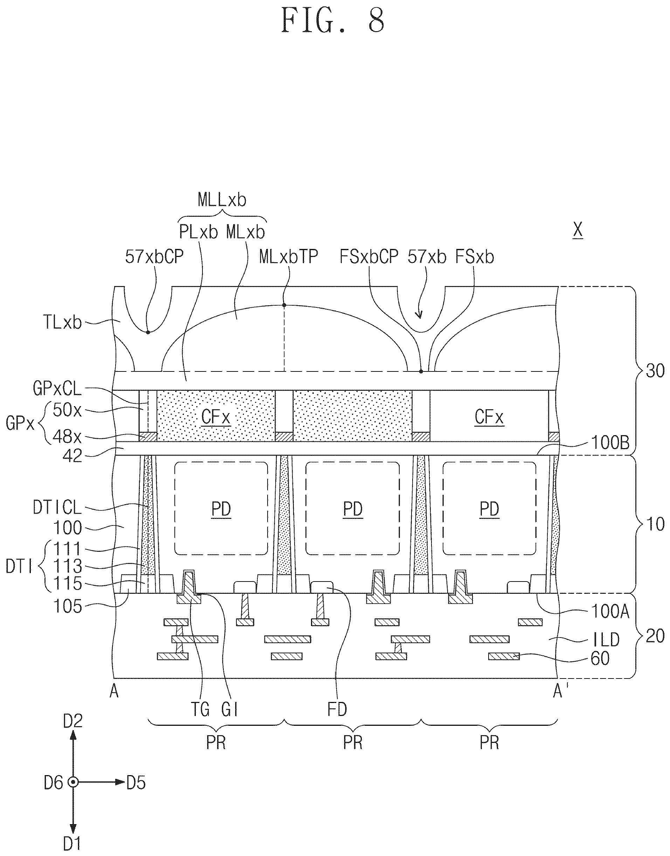

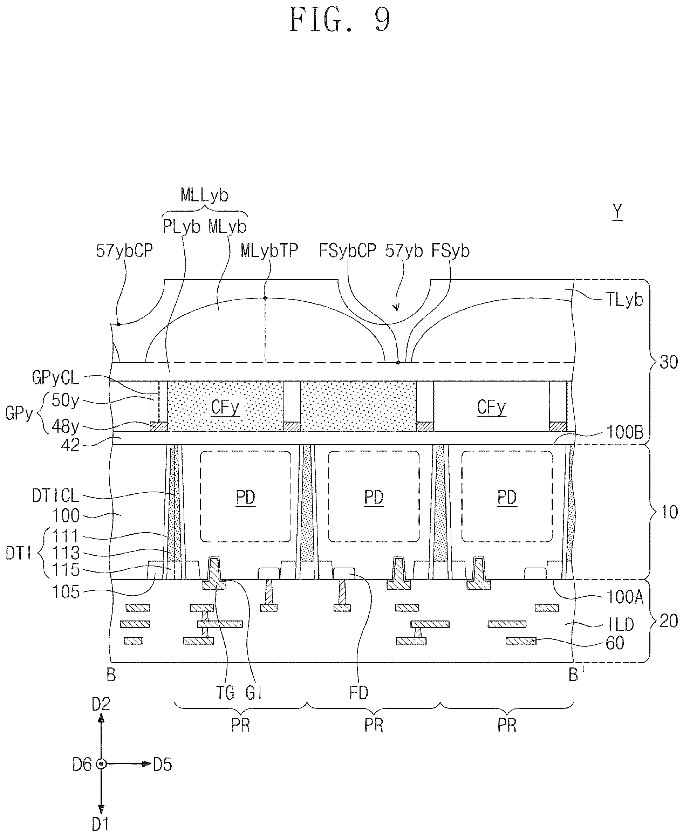

FIG. 8 is a sectional view taken along the line A-A' of FIG. 3B, according to an embodiment. FIG. 9 is a sectional view taken along the line B-B' of FIG. 3B, according to an embodiment. Regions X and Y of FIGS. 8 and 9 may include and/or may be similar in many respects to the regions X and Y respectively described above with reference to FIGS. 4 to 7, and may include additional features not mentioned above. Consequently, repeated descriptions of the regions X and Y described above with reference to FIGS. 4 to 7 may be omitted for the sake of brevity.

An image sensor 1000, according to an embodiment, is further described with reference to FIGS. 8 and 9. The image sensor 1000 may include the photoelectric conversion layer 10, the pixel circuit layer 20, and the optically-transparent layer 30, when viewed in a vertical section.

The optically-transparent layer 30 may include the anti-reflection layer 42, a grid structure (e.g., a first grid structure GPxb or a second grid structure GPyb), the center or edge color filters CFx or CFy, a micro lens layer (e.g., a first micro lens layer MLLxb or a second micro lens layer MLLyb), and a topmost planarization layer (e.g., a first topmost planarization layer TLxb or a second topmost planarization layer TLyb) on the first or second micro lens layer MLLxb or MLLyb. The first or second topmost planarization layer TLxb or TLyb may include an upper recessed portion (e.g., a first upper recessed portion 57xb or a second upper recessed portion 57yb), which may be recessed toward the substrate.

FIG. 8 illustrates a detailed structure of the image sensor in the center pixel region X.

In the center pixel region X, the color filter group, the first micro lens layer MLLxb, and the first topmost planarization layer TLxb may not be shifted from each other.

The first micro lens layer MLLxb may include a first lens planarization layer PLxb in contact with the color filter group and a first micro lens MLxb on the lens planarization layer PLxb. The first lens planarization layer PLxb may have a first flat top surface FSxb that may be exposed.

The first micro lens MLxb may have a first lens center point MLxbTP. The center point of the first flat top surface FSxb of the first lens planarization layer PLxb may be referred to as a first center point FSxbCP of the first flat top surface FSxb.

The first topmost planarization layer TLxb may be provided on the first micro lens layer MLLxb. The first topmost planarization layer TLxb may include the first upper recessed portion 57xb. The first upper recessed portion 57xb may have a first recess center point 57xbCP, which may be provided at the lowermost portion of the upper recessed portion 57xb. The first recess center point 57xbCP may be referred to as a point of the first upper recessed portion 57xb that is closest to the substrate 100.

In the center pixel region X, the first micro lens MLxb may be disposed between the first upper recessed portions 57xb, which are closely spaced apart from each other. The first lens center point MLxbTP may be located between the first recess center points 57xbCP, which may be closely spaced apart from each other. The first lens center point MLxbTP may be overlapped with the first grid structure GPxb. The first lens center point MLxbTP may be overlapped with the first grid center line GPxCL of the first grid structure GPxb.

The first upper recessed portion 57xb, the first flat top surface FSxa, and the deep device isolation pattern DTI may be overlapped with each other. The first recess center point 57xaCP of the first upper recessed portion 57xa, the first center point FSxaCP of the first flat top surface FSxa, and the device isolation center line DTICL of the deep device isolation pattern DTI may be located on the same vertical line. Each of the first micro lenses MLxb may be overlapped with a plurality of photoelectric conversion parts PD. Each of the first micro lenses MLxb may be overlapped with a plurality of center color filters CFx. For example, each of the first micro lenses MLxb may be overlapped with at least four (4) photoelectric conversion parts PD.

FIG. 9 illustrates a detailed structure of the image sensor 1000 in the edge pixel region Y.

In the edge pixel region Y, the color filter group, the second micro lens layer MLLyb, and the second topmost planarization layer TLyb may be shifted from each other.

A second lens center point MLybTP of a second micro lens MLyb may not be overlapped with the second grid structure GPyb. The second lens center point MLybTP may be overlapped with the edge color filter CFy. The second grid structure GPyb may be overlapped with the second micro lens MLyb. For example, each of the second micro lenses MLyb may be overlapped with a plurality of grid structures GPyb.

The second upper recessed portion 57yb, a second flat top surface FSyb, and the deep device isolation pattern DTI may not be overlapped with each other. A second recess center point 57ybCP of the second upper recessed portion 57yb, a second center point FSybCP of the second flat top surface FSyb, and the device isolation center line DTICL of the deep device isolation pattern DTI may be located on different vertical lines from each other. Each of the second micro lenses MLyb may be overlapped with a plurality of photoelectric conversion parts PD. Each of the second micro lenses MLy may be overlapped with a plurality of center color filters CFy. For example, each of the second micro lenses MLyb may be overlapped with at least four (4) photoelectric conversion parts PD. As another example, each of the second micro lenses MLyb may be overlapped with at least four (4) edge color filters CFy.

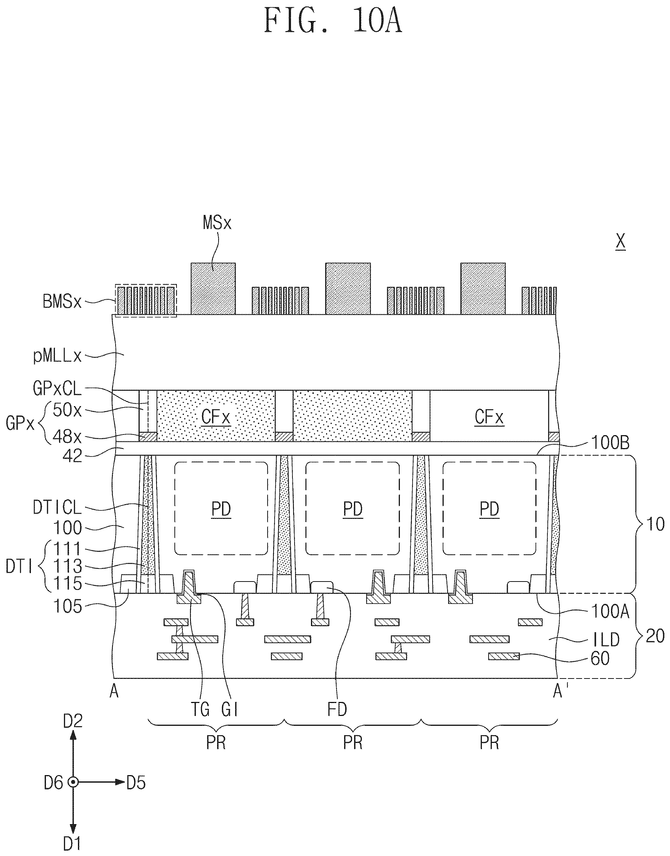

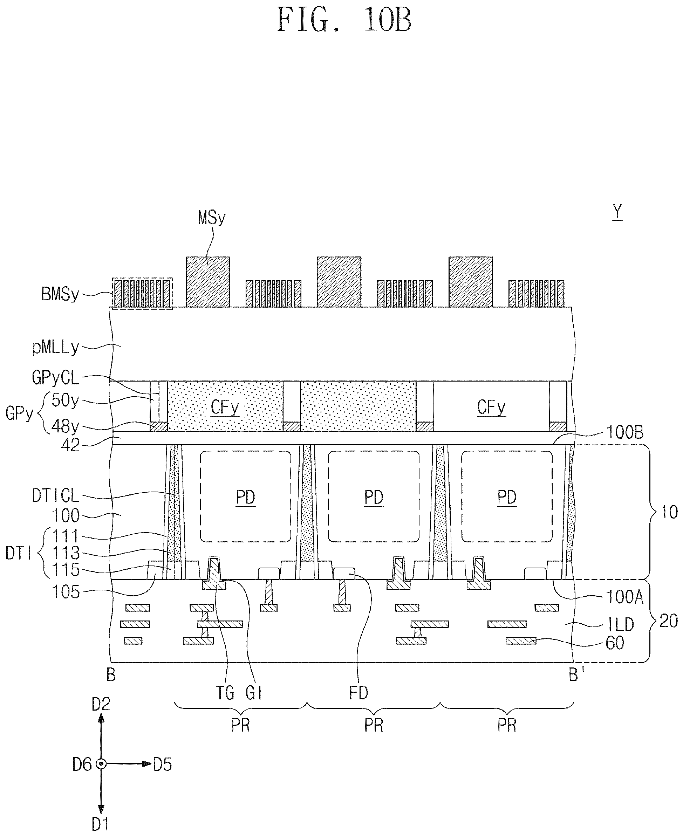

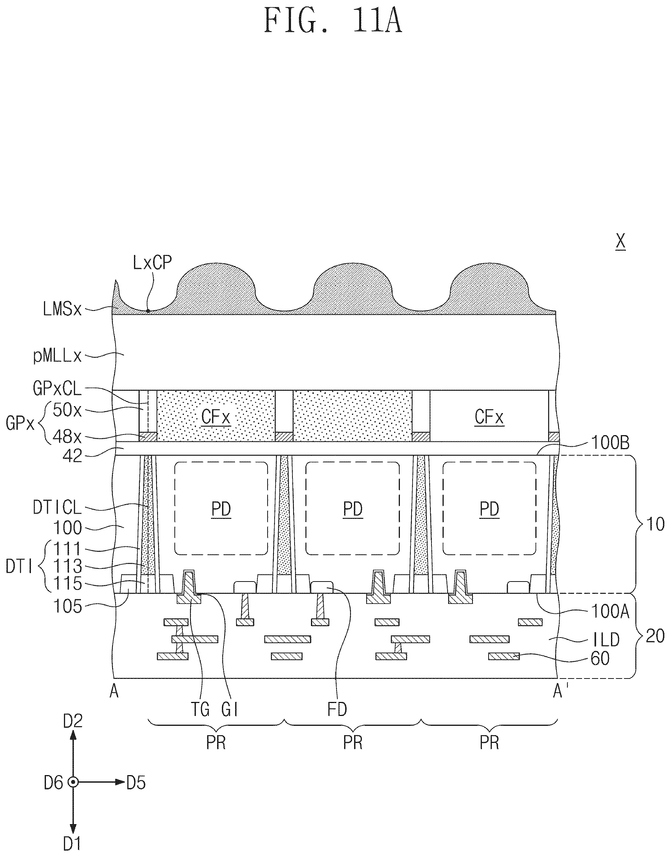

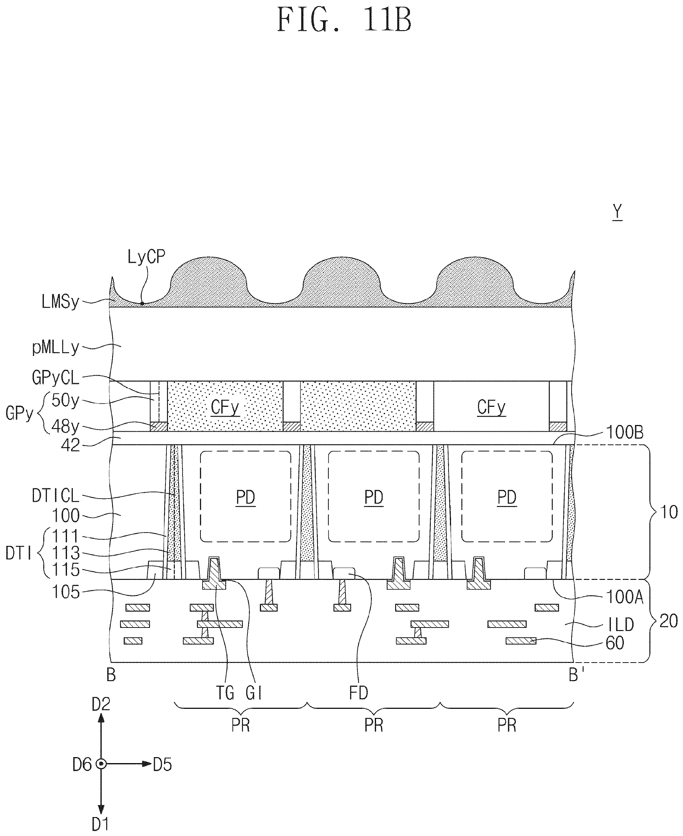

FIGS. 10A and 11A are sectional views, which are taken along the line A-A' of FIG. 3B to illustrate a method of fabricating an image sensor, according to an embodiment. FIGS. 10B and 11B are sectional views, which are taken along the line B-B' of FIG. 3B to illustrate a method of fabricating an image sensor 1000, according to an embodiment. Regions X and Y of FIGS. 10A to 11B may include and/or may be similar in many respects to the regions X and Y respectively described above with reference to FIGS. 4 to 9, and may include additional features not mentioned above. Consequently, repeated descriptions of the regions X and Y described above with reference to FIGS. 4 to 9 may be omitted for the sake of brevity.

The image sensor fabrication method of FIGS. 4 to 5 is further described with reference to FIGS. 10A, 10B, 11A, and 11B. That is, the fabrication method for the image sensor 1000 in the center pixel region X is further described with reference to FIGS. 10A and 11A, and the image sensor fabrication method in the edge pixel region Y is further described with reference to FIGS. 10B and 11B.

Referring to FIG. 10A, the photoelectric conversion layer 10, the pixel circuit layer 20, the anti-reflection layer 42 on the photoelectric conversion layer 10, and the first grid structure GPx and the center color filter CFx on the anti-reflection layer 42 may be provided in the center pixel region X. A first preliminary micro lens layer pMLLx may be formed on the first grid structure GPx and the center color filter CFx. The first preliminary micro lens layer pMLLx may be coated to cover all of the first grid structure GPx and the center color filter CFx.

A first mask pattern MSx and a first barcode mask pattern BMSx may be formed on the first preliminary micro lens layer pMLLx. The first mask pattern MSx and the first barcode mask pattern BMSx may be spaced apart from each other. The first mask pattern MSx and the first barcode mask pattern BMSx may be alternately formed to be spaced apart from each other.

The first mask pattern MSx may be composed of a single photoresist pattern. The first barcode mask pattern BMSx may include a plurality of separated photoresist patterns. A width of each photoresist pattern in the first mask pattern MSx may be larger than a width of each of the separated photoresist patterns of the first barcode mask pattern BMSx. In an embodiment, the separated photoresist patterns of the first barcode mask pattern BMSx may be provided such that a width of the photoresist pattern at an outer location is larger than a width of the photoresist pattern at an inner location.

The first barcode mask pattern BMSx may be provided to be overlapped with the first grid structure GPx. The first mask pattern MSx may be provided to be overlapped with the center color filter CFx. A center of the first barcode mask pattern BMSx may be provided to be overlapped with the first grid center line GPxCL of the first grid structure GPx.

Referring to FIG. 10B, the photoelectric conversion layer 10, the pixel circuit layer 20, the anti-reflection layer 42 on the photoelectric conversion layer 10, and the second grid structure GPy and the edge color filter CFy on the anti-reflection layer 42 may be provided in the edge pixel region Y.

A second mask pattern MSy and a second barcode mask pattern BMSy may be formed on a second preliminary micro lens layer pMLLy.

In the edge pixel region Y, the second barcode mask pattern BMSy may be provided to be overlapped with the second grid structure GPy. The second mask pattern MSy may be provided to be overlapped with the edge color filter CFy. A center of the second barcode mask pattern BMSy may not be overlapped with the second grid center line GPyCL of the second grid structure GPy. That is, the second barcode mask pattern BMSy and the second mask pattern MSy may be shifted with the second preliminary micro lens layer pMLLy.

Referring to FIGS. 11A and 11B, the mask pattern and the barcode mask pattern may be reflowed. The photoresist patterns, which are included in the mask pattern and the barcode mask pattern, may be melted through the reflow process.

Referring to FIG. 11A, the first mask pattern MSx and the first barcode mask pattern BMSx in the center pixel region X may be reflowed. As a result, a first lens mask pattern LMSx may be formed. A top surface of the first lens mask pattern LMSx may include a curved surface.

A reflowed portion of the first barcode mask pattern BMSx may include the lens mask pattern LMSx, which may be recessed toward the substrate (e.g., in the first direction D1) and may have a concave shape.

A reflowed portion of the first mask pattern MSx may include the first lens mask pattern LMSx, which may be convex in an opposite direction of the substrate (e.g., in the second direction D2).

The convex first lens mask pattern LMSx may be overlapped with the center color filter CFx. The concave first lens mask pattern LMSx may be overlapped with the first grid structure GPx.

Thereafter, an etch-back process may be performed using the first lens mask pattern LMSx as a mask. For example, the first micro lens layer MLLx in the center pixel region X of FIG. 3 may be formed through the etch-back process.

Referring to FIG. 11B, the second mask pattern MSy and the second barcode mask pattern BMSy in the edge pixel region Y may be reflowed. As a result, a second lens mask pattern LMSy may be formed. A top surface of the second lens mask pattern LMSy may include a curved surface. A reflowed portion of the second barcode mask pattern BMSy may include the second lens mask pattern LMSy, which may be recessed toward the substrate (e.g., in the first direction D1) and may have a concave shape.

A reflowed portion of the second mask pattern MSy may include the second lens mask pattern LMSy, which may be convex in an opposite direction of the substrate (e.g., in the second direction D2).

The convex second lens mask pattern LMSy may be overlapped with the edge color filter CFy. The concave second lens mask pattern LMSy may be overlapped with the second grid structure GPy.

Thereafter, an etch-back process may be performed using the lens mask pattern LMSy as a mask. For example, the second micro lens layer MLLy in the edge pixel region Y of FIG. 4 may be formed through the etch-back process.

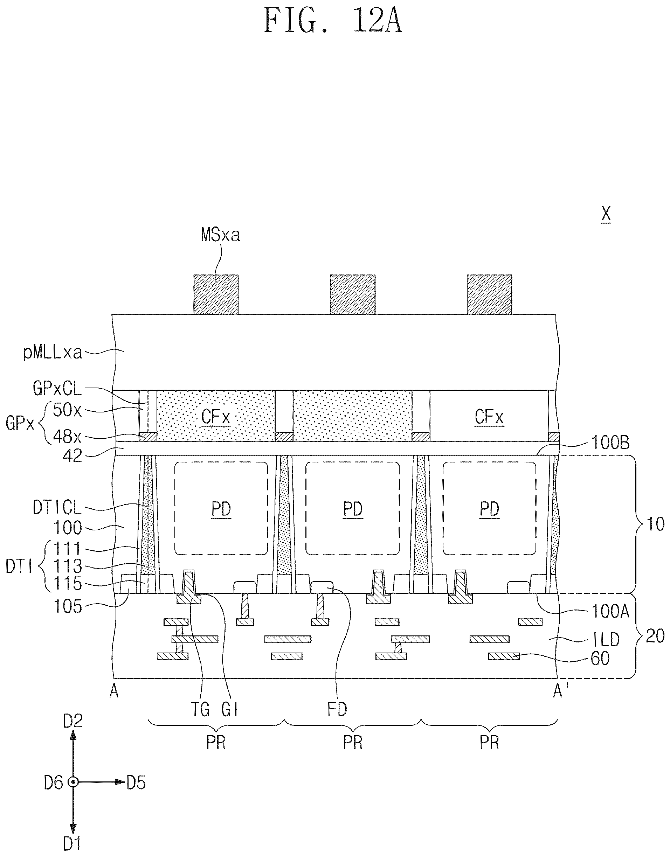

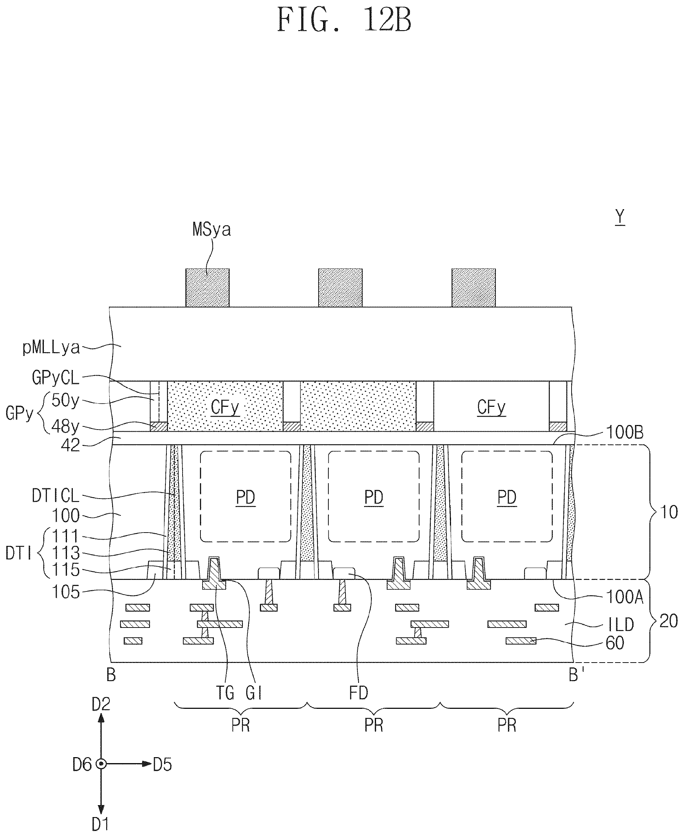

FIGS. 12A to 15A are sectional views, which are taken along the line A-A' of FIG. 3B to illustrate a method of fabricating an image sensor, according to an embodiment. FIGS. 12B to 15B are sectional views, which are taken along the line B-B' of FIG. 3B to illustrate a method of fabricating an image sensor, according to an embodiment. Regions X and Y of FIGS. 12A to 15B may include and/or may be similar in many respects to the regions X and Y respectively described above with reference to FIGS. 4 to 11B, and may include additional features not mentioned above. Consequently, repeated descriptions of the regions X and Y described above with reference to FIGS. 4 to 11B may be omitted for the sake of brevity.

The image sensor fabrication method of FIGS. 6 to 7 is further described with reference to FIGS. 12A to 15A and 12B to 15B. That is, the fabrication method for the image sensor 1000 in the center pixel region X of FIG. 6 is further described with reference to FIGS. 12A to 15A, and the fabrication method for the image sensor 1000 in the edge pixel region Y is further described with reference to FIG. 12B to 15B.

Referring to FIG. 12A, the photoelectric conversion layer 10, the pixel circuit layer 20, the anti-reflection layer 42 on the photoelectric conversion layer 10, and the first grid structure GPx and the center color filter CFx on the anti-reflection layer 42 may be provided in the center pixel region X. The first preliminary micro lens layer pMLLx may be formed on the first grid structure GPx and the center color filter CFx. The first preliminary micro lens layer pMLLx may be coated to cover all of the first grid structure GPx and the center color filter CFx.

First mask patterns MSxa may be provided on the first preliminary micro lens layer pMLLx to be spaced apart from each other. The first mask pattern MSxa may be provided to expose a portion of a top surface of the first preliminary micro lens layer pMLLx.

The first mask pattern MSxa may be overlapped with the center color filter CFx. A center of the first mask pattern MSxa may be overlapped with a center of the center color filter CFx.

Referring to FIG. 12B, the photoelectric conversion layer 10, the pixel circuit layer 20, the anti-reflection layer 42 on the photoelectric conversion layer 10, and the second grid structure GPy and the edge color filter CFy on the anti-reflection layer 42 may be provided in the edge pixel region Y.

Second mask pattern MSya may be provided on a second preliminary micro lens layer pMLLya. The second mask pattern MSya may be overlapped with the edge color filter CFy. A center of the second mask pattern MSya may not be overlapped with a center of the edge color filter CFy.

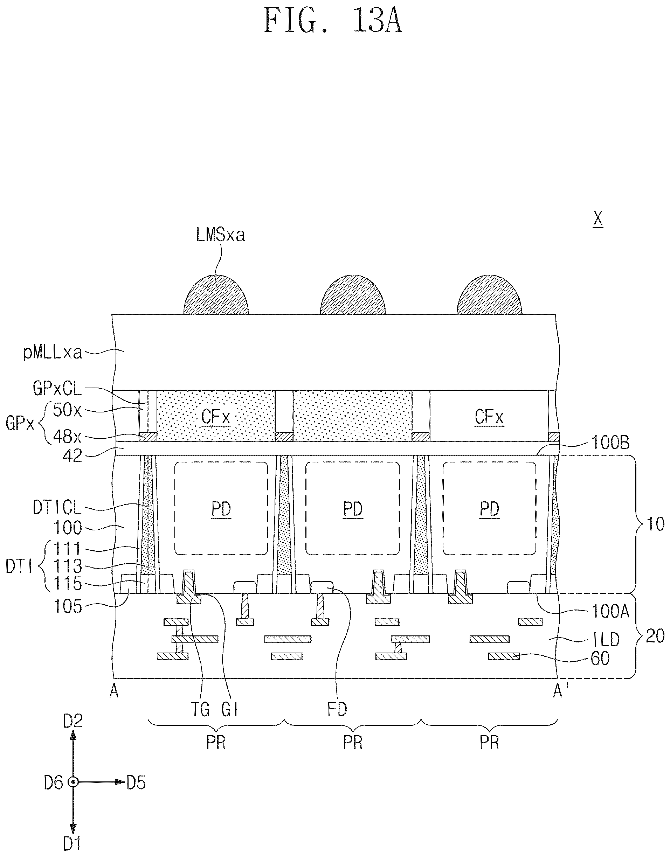

Referring to FIG. 13A, the first mask pattern MSxa may be reflowed, in the center pixel region X. As a result of the reflow of the first mask pattern MSxa, a first lens mask pattern LMSxa may be formed. A top surface of the first lens mask pattern LMSxa may include a curved surface. A reflowed portion of the first mask pattern MSxa may include the first lens mask pattern LMSxa, which may be convex in an opposite direction of the substrate (e.g., in the second direction D2).

In an embodiment, a plurality of first lens mask patterns LMSxa may be spaced apart from each other. The first lens mask pattern LMSxa may be overlapped with the center color filter CFx. A center of the first lens mask pattern LMSxa may be overlapped with a center of the center color filter CFx.

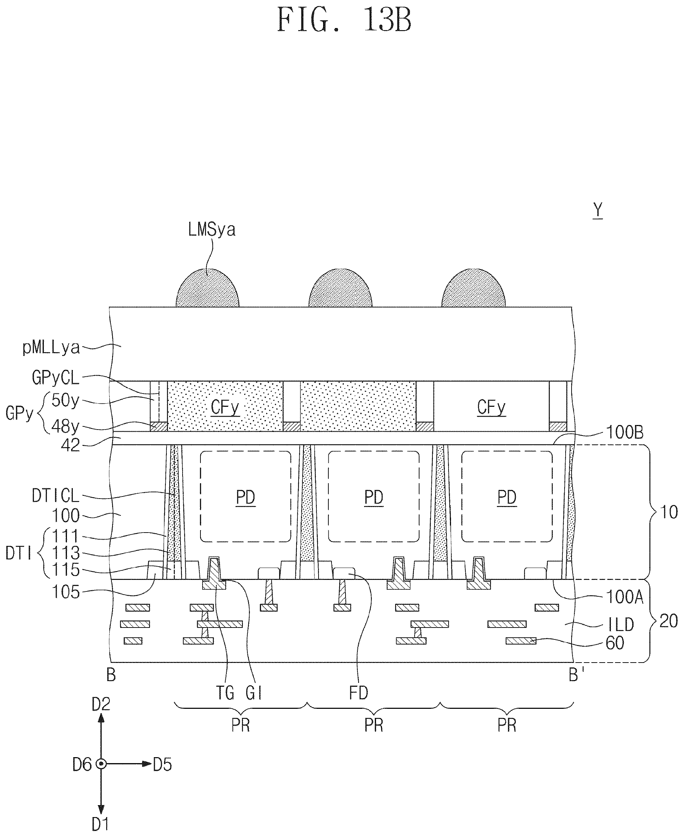

Referring to FIG. 13B, the second mask pattern MSya may be reflowed, in the edge pixel region Y. As a result, a second lens mask pattern LMSya may be formed. A top surface of the second lens mask pattern LMSy may include a curved surface. A reflowed portion of the second mask pattern MSya may include the second lens mask pattern LMSya, which may be convex in an opposite direction of the substrate (e.g., in the second direction D2).

The convex second lens mask pattern LMSya may be overlapped with the edge color filter CFy. A center of the second lens mask pattern LMSya may not be overlapped with a center of the edge color filter CFy.

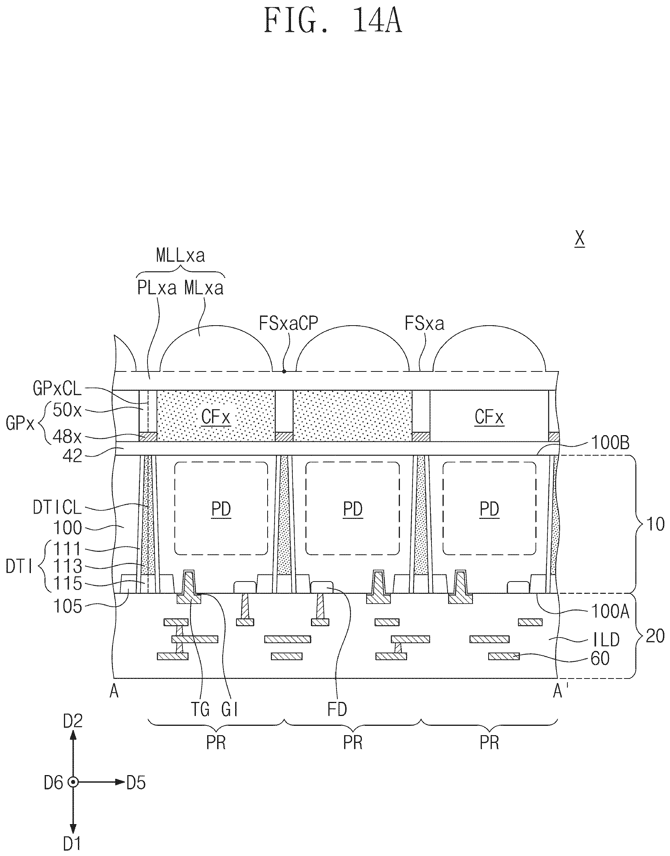

Referring to FIG. 14A, in the center pixel region X, an etch-back process may be performed using the first lens mask pattern LMSxa as a mask. As a result, the first micro lens layer MLLxa may be formed in the center pixel region X. The first micro lens layer MLLxa may form the first lens planarization layer PLxa and the first micro lens MLxa. The first micro lens layer MLLxa may be formed to expose the first flat top surface FSxa between the first micro lenses MLxa. The first micro lens layer MLLxa may be formed such that the first center point FSxaCP of the first flat top surface FSxa is overlapped with the first grid center line GPxCL of the first grid structure GPx.

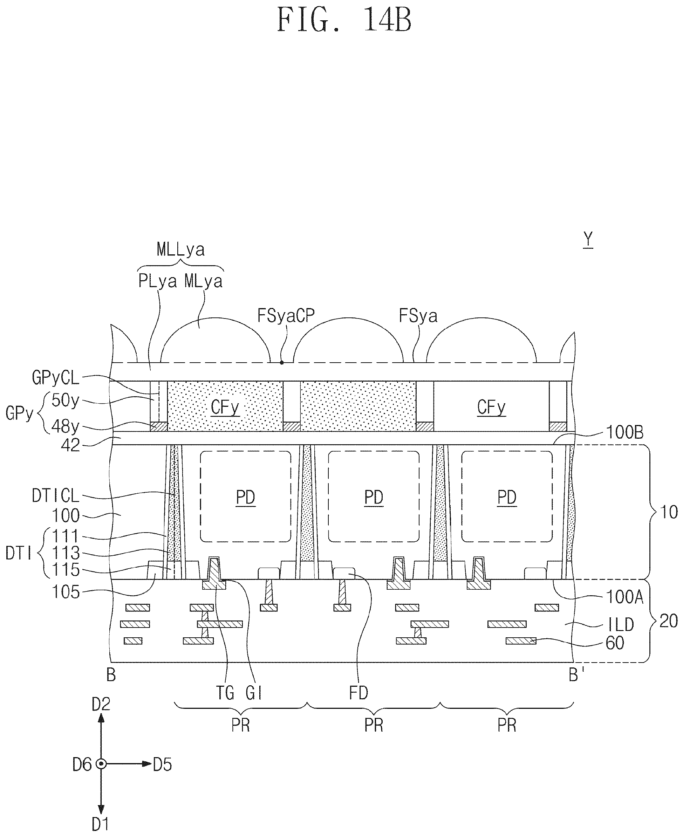

Referring to FIG. 14B, in the edge pixel region Y, an etch-back process may be performed using the second lens mask pattern LMSya as a mask. As a result, the second micro lens layer MLLya may be formed in the edge pixel region Y. The second micro lens layer MLLya may form a second lens planarization layer PLya and the second micro lens MLya. The second micro lens layer MLLya may be formed to expose the second flat top surface FSya between the second micro lens MLya. The second micro lens layer MLLya may be formed such that the second center point FSyaCP of the second flat top surface FSya is not overlapped with the second grid center line GPyCL of the second grid structure GPy. The micro lens layer MLLya may be formed to be shifted from the edge color filter CFy.

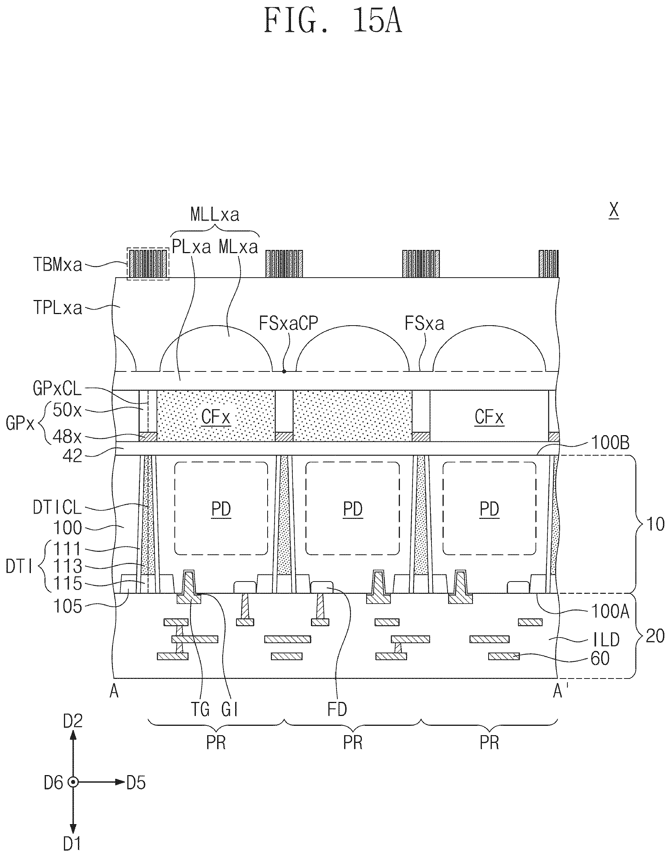

Referring to FIG. 15A, a first preliminary topmost planarization layer TPLxa may be formed on the first micro lens layer MLLxa, in the center pixel region X. The first preliminary topmost planarization layer TPLxa may be formed to fully cover the first micro lens layer MLLxa. A first topmost barcode mask TBMxa may be formed on the first preliminary topmost planarization layer TPLxa. A plurality of first topmost barcode masks TBMxa may be formed to be spaced apart from each other. A portion of the first preliminary topmost planarization layer TPLxa may be exposed.

The first topmost barcode mask TBMxa may include a plurality of first separated photoresist patterns. In an embodiment, the first separated photoresist patterns of the first topmost barcode mask TBMxa may be provided such that a width of the first photoresist pattern at an outer location is larger than a width of the first photoresist pattern at an inner location.

The first topmost barcode mask TBMxa may be provided to be overlapped with the first grid structure GPx. The first topmost barcode mask TBMxa may be provided to be overlapped with the center color filter CFx. A center of the first topmost barcode mask TBMxa may be overlapped with the first grid center line GPxCL of the first grid structure GPx. A center of the first topmost barcode mask TBMxa may be overlapped with the center point FSxaCP of the flat top surface FSxa.

Thereafter, similar to the embodiment of FIG. 11A, the first topmost barcode mask TBMxa may be reflowed to form a mask pattern, which may be concave in the second direction D2, and an etch-back process may be performed using the concave mask pattern as a mask. As a result, the first upper recessed portion 57xa of FIG. 6 may be formed. The image sensor 1000 in the center pixel region X may be formed in this manner.

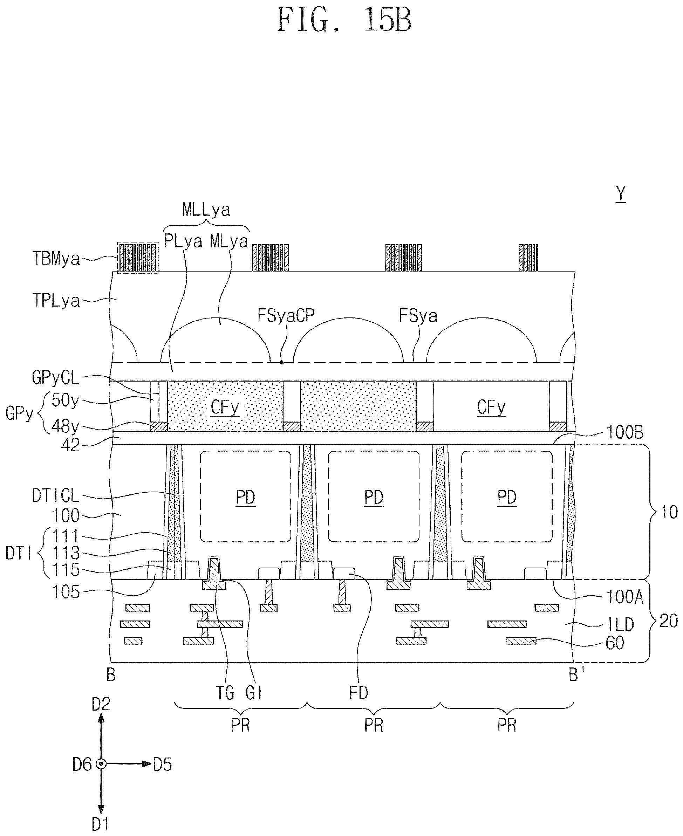

Referring to FIG. 15B, a second preliminary topmost planarization layer TPLya may be formed on the second micro lens layer MLLya in the edge pixel region Y. The second preliminary topmost planarization layer TPLya may be formed to fully cover the second micro lens layer MLLya. A second topmost barcode mask TBMya may be formed on the second preliminary topmost planarization layer TPLya. In an embodiment, a plurality of second topmost barcode masks TBMya may be formed to be spaced apart from each other. A portion of the second preliminary topmost planarization layer TPLya may be exposed.

The second topmost barcode mask TBMya may include a plurality of second separated photoresist patterns. In an embodiment, the second separated photoresist patterns of the second topmost barcode mask TBMya may be provided such that a width of the photoresist pattern at an outer location is larger than a width of the photoresist pattern at an inner location.

The second topmost barcode mask TBMya may be formed such that it may not be overlapped with the second grid center line GPyCL of the second grid structure GPy. A center of the second topmost barcode mask TBMya may not be overlapped with the center point FSyaCP of the second flat top surface FSya. The center of the second topmost barcode mask TBMya may not be overlapped with the topmost end of the second micro lens MLya. As used herein, the expression "elements or points are not overlapped with each other" may refer to the elements and/or the points being located on different vertical lines from each other.

Thereafter, similar to the embodiment of FIG. 11B, the second topmost barcode mask TBMya may be reflowed to form a mask pattern, which may be concave in the second direction D2, and an etch-back process may be performed using the concave mask pattern as a mask. As a result, the second upper recessed portion 57ya of FIG. 7 may be formed. The image sensor 1000 in the edge pixel region Y may be formed in this manner.

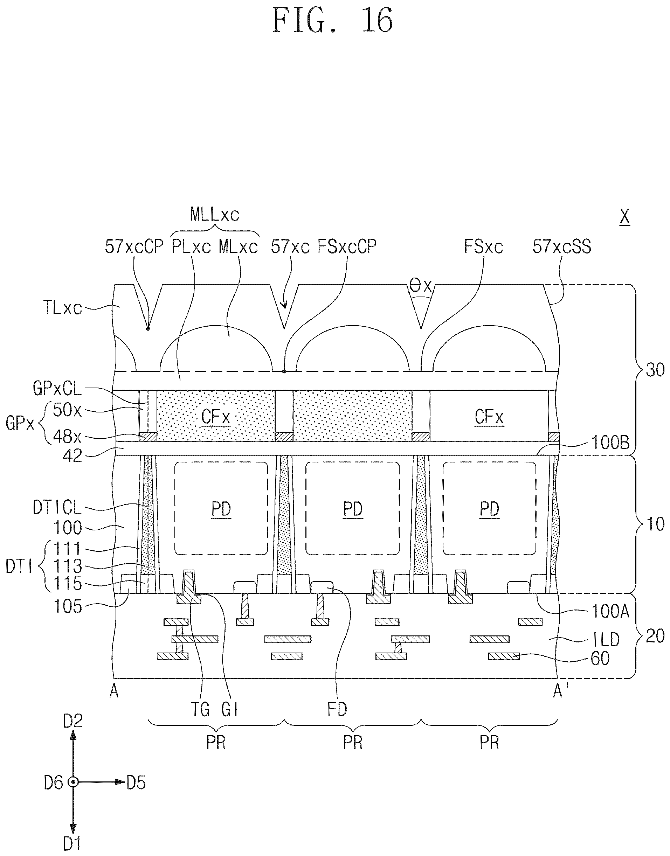

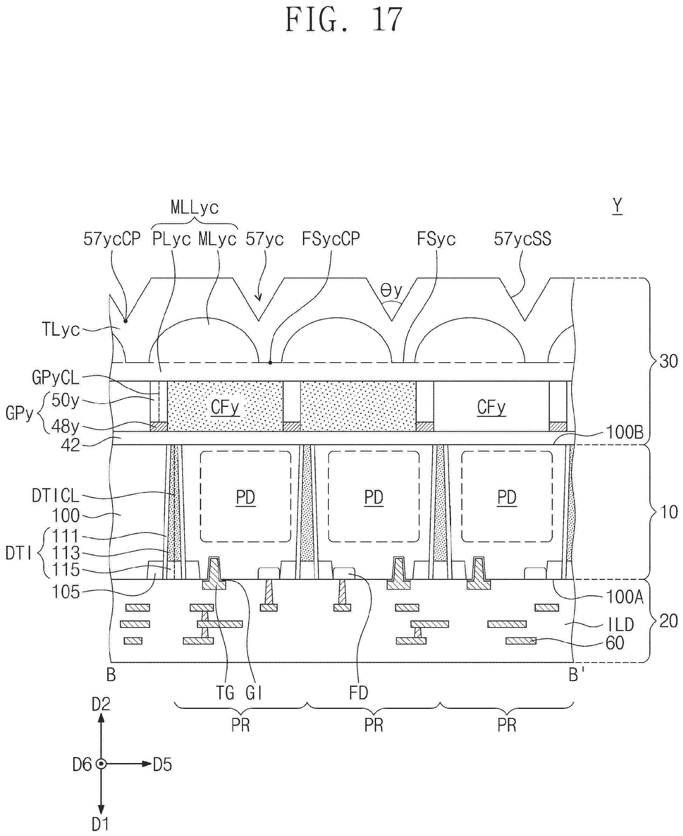

FIG. 16 is a sectional view taken along the line A-A' of FIG. 3B, according to an embodiment. FIG. 17 is a sectional view taken along the line B-B' of FIG. 3B, according to an embodiment. Regions X and Y of FIGS. 16 and 17 may include and/or may be similar in many respects to the regions X and Y respectively described above with reference to FIGS. 4 to 15B, and may include additional features not mentioned above. Consequently, repeated descriptions of the regions X and Y described above with reference to FIGS. 4 to 15B may be omitted for the sake of brevity.

An image sensor 1000, according to an embodiment, is further described with reference to FIGS. 16 and 17. The image sensor 1000 may include the photoelectric conversion layer 10, the pixel circuit layer 20, and the optically-transparent layer 30, when viewed in a vertical section.

The optically-transparent layer 30 may include the anti-reflection layer 42, a grid structure (e.g., a first grid structure GPxc or a second grid structure GPyc), the center or edge color filters CFx or CFy, a micro lens layer (e.g., a first micro lens layer MLLxc or a second micro lens layer MLLyc), and a topmost planarization layer (e.g., a first topmost planarization layer TLxc or a second topmost planarization layer TLyc) on the first or second micro lens layer MLLxc or MLLyc. The first or second topmost planarization layer TLxc or TLyc may include an upper recessed portion (e.g., a first upper recessed portion 57xc or a second upper recessed portion 57yc), which may be recessed toward the substrate.

FIG. 16 illustrates a detailed structure of the image sensor 1000 in the center pixel region X. The first topmost planarization layer TLxc may be provided on the first micro lens layer MLLxc. The first topmost planarization layer TLxc may include the first upper recessed portion 57xc. The first upper recessed portion 57xc may have a first recess center point 57xcCP, which may be provided at the lowermost portion of the first upper recessed portion 57xc. The first recess center point 57xcCP may be referred to as a point of the first upper recessed portion 57xc that is closest to the substrate 100.

A width of the first upper recessed portion 57xc may decrease as a distance to the substrate 100 decreases. The width of the first upper recessed portion 57xc may decrease at a constant change rate, as a distance to the substrate 100 decreases. A side surface of the first upper recessed portion 57xc may have a first inclined side surface 57xcSS. The first inclined side surface 57xcSS may have a flat surface. The first upper recessed portion 57xc may have a first recess angle θx. For example, the first recess angle θx may range from about 0° to about 180°.

The width of the first upper recessed portion 57xc may decrease at a constant change rate, as a distance to the substrate 100 decreases, and the first inclined side surface 57xcSS may be inclined at a first recess angle θx, as the first inclined side surface 57xcSS may not include a curved surface.

The first upper recessed portion 57xc, the first grid structure GPx, and the deep device isolation pattern DTI may be overlapped with each other. The first recess center point 57xcCP, a center point of a first flat top surface FSxc of a first lens planarization layer PLxc, the first grid center line GPxCL of the first grid structure GPx, and the device isolation center line DTICL of the deep device isolation pattern DTI may be located on the same vertical line.

FIG. 17 illustrates a detailed structure of the image sensor 1000 in the edge pixel region Y. The second topmost planarization layer TLyc may be provided on the second micro lens layer MLLyc. The second topmost planarization layer TLyc may include the second upper recessed portion 57yc. The second upper recessed portion 57yc may have a second recess center point 57ycCP, which may be provided at the lowermost portion of the second upper recessed portion 57yc. The second recess center point 57ycCP may be a point of the upper recessed portion 57yc that is closest to the substrate 100.

A width of the second upper recessed portion 57yc may decrease as a distance to the substrate 100 decreases. The width of the second upper recessed portion 57yc may decrease at a constant change rate, as a distance to the substrate 100 decreases. A side surface of the second upper recessed portion 57yc may have a second inclined side surface 57ycSS. The second inclined side surface 57ycSS may have a flat surface. The second upper recessed portion 57yc may have a second recess angle θy. In an embodiment, the second recess angle θy may range from about 0° to about 180°.

The width of the second upper recessed portion 57yc may decrease at a constant change rate, as a distance to the substrate 100 decreases, and the second inclined side surface 57ycSS may be inclined at a second recess angle θy, and the second inclined side surface 57ycSS may not have a curved surface.

In the edge pixel region Y, the second micro lens layer MLLyc and the second topmost planarization layer TLyc may be shifted from each other.

In the edge pixel region Y, the second upper recessed portion 57yc, a second flat top surface FSyc, and the deep device isolation pattern DTI may not be overlapped with each other. The second recess center point 57ycCP of the second upper recessed portion 57yc, a second center point FSycCP of the second flat top surface FSyc, and the device isolation center line DTICL of the deep device isolation pattern DTI may be located on different vertical lines from each other.

In the center pixel region X, a width of the topmost portion of the first upper recessed portion 57xc may be different from a width of the topmost portion of the second upper recessed portion 57yc in the edge pixel region Y. As an example, the width of the topmost portion of the first upper recessed portion 57xc in the center pixel region X may be smaller than the width of the topmost portion of the second upper recessed portion 57yc in the edge pixel region Y. The first recess angle θx in the center pixel region X may be smaller than the second recess angle θy in the edge pixel region Y.

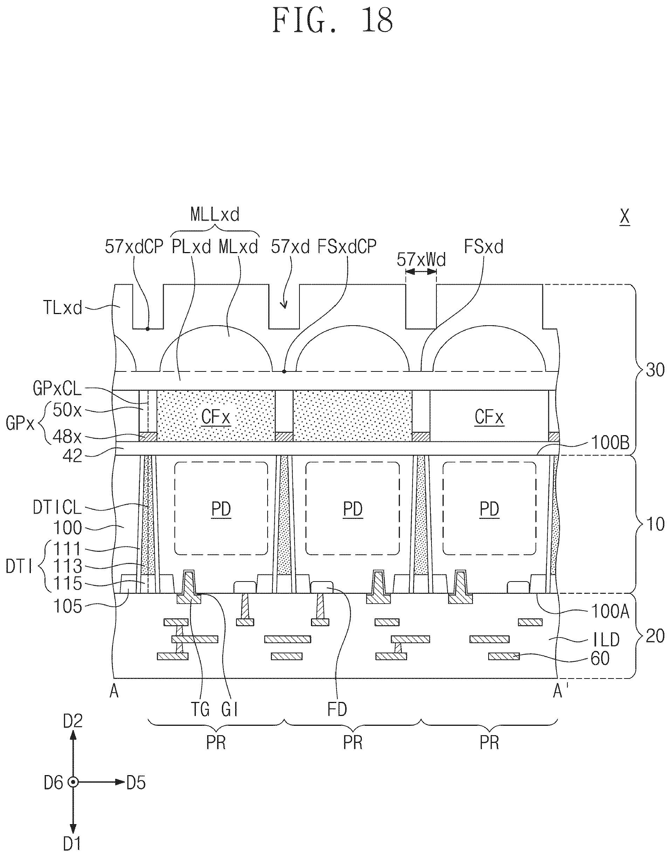

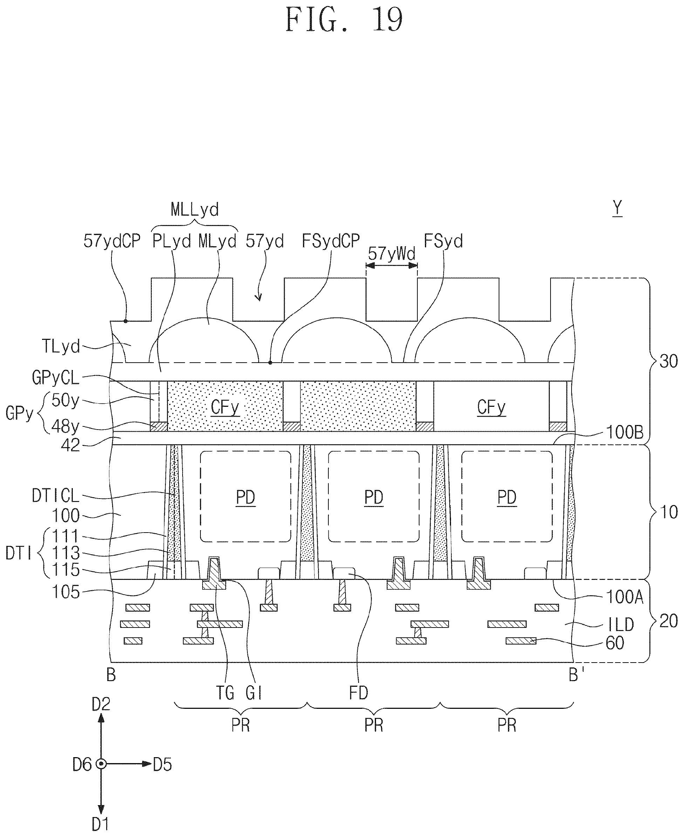

FIG. 18 is a sectional view taken along the line A-A' of FIG. 3B, according to an embodiment. FIG. 19 is a sectional view taken along the line B-B' of FIG. 3B, according to an embodiment. Regions X and Y of FIGS. 18 and 19 may include and/or may be similar in many respects to the regions X and Y respectively described above with reference to FIGS. 4 to 17, and may include additional features not mentioned above. Consequently, repeated descriptions of the regions X and Y described above with reference to FIGS. 4 to 17 may be omitted for the sake of brevity.

An image sensor 1000, according to an embodiment, is further described with reference to FIGS. 18 and 19. The image sensor 1000 may include the photoelectric conversion layer 10, the pixel circuit layer 20, and the optically-transparent layer 30, when viewed in a vertical section.

The optically-transparent layer 30 may include the anti-reflection layer 42, a grid structure (e.g., a first grid structure GPxd or a second grid structure GPyd), the center or edge color filters CFx or CFy, a micro lens layer (e.g., a first micro lens layer MLLxd or a second micro lens layer MLLyd), and a topmost planarization layer (e.g., a first topmost planarization layer TLxd or a second topmost planarization layer TLyd) on the first or second micro lens layer MLLxd or MLLyd. The first or second topmost planarization layer TLxd or TLyd may include an upper recessed portion (e.g., a first upper recessed portion 57xd or a second upper recessed portion 57yd), which may be recessed toward the substrate.

FIG. 18 illustrates a detailed structure of the image sensor 1000 in the center pixel region X. The first topmost planarization layer TLxd may be provided on the first micro lens layer MLLxd. The first topmost planarization layer TLxd may include the first upper recessed portion 57xd. The first upper recessed portion 57xd may have a first recess center point 57xdCP, which may be provided at a center of the lowermost surface of the first upper recessed portion 57xd. The first recess center point 57xdCP may be referred to as a point of the first upper recessed portion 57xd that is closest to the substrate 100.

A first width 57xWd of the first upper recessed portion 57xd may be substantially constant and/or the same value regardless of a distance from the substrate 100. A side surface of the first upper recessed portion 57xd may be perpendicular to the substrate 100.

The first upper recessed portion 57xd, the first grid structure GPx, and the deep device isolation pattern DTI may be overlapped with each other. The first recess center point 57xdCP, a center point of a first flat top surface FSxd of a first lens planarization layer PLxd, the first grid center line GPxCL of the first grid structure GPx, and the device isolation center line DTICL of the deep device isolation pattern DTI may be located on the same vertical line.

FIG. 19 illustrates a detailed structure of the image sensor 1000 in the edge pixel region Y. The second topmost planarization layer TLyd may be provided on the second micro lens layer MLLyd. The second topmost planarization layer TLyd may include the second upper recessed portion 57yd. The second upper recessed portion 57yd may have a second recess center point 57ydCP, which may be provided at a center of the lowermost surface of the second upper recessed portion 57yd. The second recess center point 57ydCP may be referred to as a point of the upper recessed portion 57yd that is closest to the substrate 100.

A second width 57yWd of the second upper recessed portion 57yd may be substantially constant and/or the same value regardless of a distance from the substrate 100. A side surface of the second upper recessed portion 57yd may be perpendicular to the substrate 100.

In the edge pixel region Y, the second micro lens layer MLLyd and the second topmost planarization layer TLyd may be shifted from each other.

In the edge pixel region Y, the second upper recessed portion 57yd, a second flat top surface FSyd, and the deep device isolation pattern DTI may not be overlapped with each other. The second recess center point 57ydCP of the second upper recessed portion 57yd, a second center point FSydCP of the second flat top surface FSyd, and the device isolation center line DTICL of the deep device isolation pattern DTI may be located on different vertical lines from each other.

The first width 57xWd of the first upper recessed portion 57xd in the center pixel region X may be different from the second width 57yWd of the second upper recessed portion 57yd in the edge pixel region Y. For example, the first width 57xWd of the first upper recessed portion 57xd in the center pixel region X may be smaller than the second width 57yWd of the second upper recessed portion 57yd in the edge pixel region Y.

According to an embodiment, an image sensor 1000 may include a center pixel region and an edge pixel region. A micro lens covering the center pixel region and the edge pixel region may include a recessed lens portion, which may be recessed toward a substrate. A topmost planarization layer may be additionally provided on the micro lens covering the center pixel region and the edge pixel region, and the planarization layer may include an upper recessed portion, which may be recessed toward the substrate.

Light, which may be incident into the image sensor, may be refracted by the recessed lens portion and the upper recessed portion, which may make it possible to suppress a cross-talk issue in the image sensor. That is, the light may be effectively incident into a photoelectric conversion region, and the sensitivity and color reproducibility of the image sensor may be improved.

According to an embodiment, a shifting distance between the recessed portions of the micro lens and the planarization layer may increase as a distance to the edge pixel region decreases. In such a case, it may be possible to increase the optical reflection efficiency, and thereby, potentially improve the sensitivity of the image sensor 1000.

## Claims

1. An image sensor, comprising:
a semiconductor substrate (100) comprising a first surface, a second surface opposite to the first surface, and a pixel array region (R1), the pixel array region comprising a center pixel region (X) and an edge pixel region (Y) at least partially enclosing the center pixel region in a plan view;
a color filter group comprising a center color filter (CFx) on the center pixel region, an edge color filter (CFy) on the edge pixel region, and a plurality of color filters;
a micro lens layer (MLLxa, MLLya) at least partially covering the color filter group; and
a topmost planarization layer (TLxa, TLya) in contact with a top surface of the micro lens layer,
wherein the micro lens layer comprises a lens planarization layer (PLx, PLy) in contact with the color filter group and a micro lens (MLxa, MLya) on the lens planarization layer,
**characterized in that** the topmost planarization layer comprises an upper recessed portion (57xa, 57ya) and a recess center point (57xaCP, 57yaCP) in each of the center pixel region and the edge pixel region, the upper recessed portion being recessed toward the semiconductor substrate, and the recess center point being defined in a lowermost portion of the upper recessed portion,
wherein, in the center pixel region, a center point (FSxaCP) of an exposed flat top surface of the lens planarization layer is at least partially vertically overlapped with the recess center point, and wherein, in the edge pixel region, a center point (FSyaCP) of the flat top surface is located on a vertical line different from the recess center point.

2. The image sensor of claim 1, wherein an inner surface of the upper recessed portion comprises a curvedly rounded portion, and
wherein a curvature of the upper recessed portion in the center pixel region is different from a curvature of the upper recessed portion in the edge pixel region.

3. The image sensor of claim 1, wherein the upper recessed portion has an inclined side surface that is inclined at an angle, and
wherein a width of the upper recessed portion decreases as a distance to the semiconductor substrate decreases.

4. The image sensor of claim 1, wherein a width of the upper recessed portion decreases at a constant change rate, and
wherein a width of an uppermost end of the upper recessed portion in the center pixel region is smaller than a width of the upper recessed portion in the edge pixel region.

5. The image sensor of claim 1, further comprising:
a plurality of photoelectric conversion parts respectively corresponding to the color filter group,
wherein the micro lens is at least partially overlapped with at least four of the plurality of photoelectric conversion parts.

6. The image sensor of claim 1, wherein the micro lens comprises a lens center point defined in a topmost portion of the micro lens, and
wherein a first vertical distance from the first surface of the semiconductor substrate to the recess center point is smaller than a second vertical distance from the first surface of the semiconductor substrate to the lens center point.

7. The image sensor of claim 1, wherein the micro lens of the micro lens layer comprises a plurality of micro lenses, which are spaced apart from each other, and
wherein the plurality of micro lenses have top surfaces that are in direct contact with the topmost planarization layer.

8. The image sensor of claim 1, further comprising:
a plurality of photoelectric conversion parts respectively corresponding to the color filter group, and
a deep device isolation pattern defining the plurality of photoelectric conversion parts,
wherein, in the center pixel region, the recess center point of the upper recessed portion is at least partially overlapped with the deep device isolation pattern, and
wherein, in the edge pixel region, the recess center point of the upper recessed portion is misaligned with the deep device isolation pattern.

9. The image sensor of claim 1, wherein a refractive index of the topmost planarization layer is lower than a refractive index of the micro lens layer, and
wherein the refractive index of the topmost planarization layer is higher than a refractive index of air.

10. An image sensor, comprising:
a semiconductor substrate (100) comprising a first surface, a second surface opposite to the first surface, and a pixel array region (R1), the pixel array region comprising a center pixel region (X) and an edge pixel region (Y) at least partially enclosing the center pixel region in a plan view;
a color filter group comprising a center color filter (CFx) on the center pixel region, an edge color filter (CFy) on the edge pixel region, and a plurality of color filters; and
a micro lens layer (MLLx, MLLy) at least partially covering the color filter group;
**characterized by** a topmost planarization layer (TLxa, TLya) on the micro lens layer (MLLx, MLLy),
wherein the micro lens layer comprises a lens planarization layer (PLxa, PLya) in contact with the color filter group and a micro lens (MLxa, MLya) on the lens planarization layer,
wherein the topmost planarization layer comprises an upper recessed portion (57xa, 57ya) and a recess center point (57xaCP, 57yaCP) in each of the center pixel region (X) and the edge pixel region (Y), the upper recessed portion being recessed toward the semiconductor substrate, and the recess center point being defined in a lowermost portion of the upper recessed portion,
wherein the micro lens comprises a lens center point (MLxaTP, MLyaTP) defined in a topmost portion of the micro lens, and
wherein a first vertical distance (L1) from the first surface to the recess center point is smaller than a second vertical distance (L2) from the first surface to the lens center point.

11. The image sensor of claim 10, wherein, in the center pixel region, a center point of an exposed flat top surface of the lens planarization layer is at least partially vertically overlapped with the recess center point, and
wherein, in the edge pixel region, a center point of the flat top surface is located on a vertical line different from the recess center point.

12. The image sensor of claim 10, further comprising:
a grid structure interposed between color filters of the color filter group,
wherein, in the center pixel region, the grid structure is at least partially overlapped with a flat top surface of the lens planarization layer and the upper recessed portion,
wherein, in the edge pixel region, the grid structure is at least partially overlapped with the micro lens, and
wherein the flat top surface comprises an at least partially exposed top surface of the lens planarization layer.

13. The image sensor of claim 10, further comprising:
a plurality of photoelectric conversion parts respectively corresponding to the color filter group; and
a deep device isolation pattern defining the plurality of photoelectric conversion parts,
wherein, in the center pixel region, the deep device isolation pattern is at least partially overlapped with an exposed flat top surface of the lens planarization layer and the upper recessed portion, and
wherein, in the edge pixel region, the deep device isolation pattern is at least partially overlapped with the edge color filter and the micro lens.

14. The image sensor of claim 10, wherein the upper recessed portion has an inclined side surface that is inclined at an angle, and
wherein, a width of the upper recessed portion decreases as a distance to the semiconductor substrate decreases.

15. The image sensor of claim 14, wherein a width of the topmost portion of the upper recessed portion in the center pixel region is smaller than a width of the topmost portion of the upper recessed portion in the edge pixel region.

## Patentansprüche

1. Ein Bildsensor, umfassend:
ein Halbleitersubstrat (100) mit einer ersten Oberfläche, einer der ersten Oberfläche gegenüberliegenden zweiten Oberfläche und einem Pixelarray-Bereich (R1), wobei der Pixelarray-Bereich einen zentralen Pixelbereich (X) und einen Randpixelbereich (Y) umfasst, der den zentralen Pixelbereich in der Draufsicht zumindest teilweise umschließt;
eine Farbfiltergruppe, die einen zentralen Farbfilter (CFx) auf dem zentralen Pixelbereich, einen Randfarbfilter (CFy) auf dem Randpixelbereich und eine Mehrzahl von Farbfiltern umfasst;
eine Mikrolinsen-Schicht (MLLxa, MLLya), die die Farbfiltergruppe zumindest teilweise bedeckt; und
eine oberste Planarisierungsschicht (TLxa, TLya), die mit einer Oberseite der Mikrolinsen-Schicht in Kontakt steht,
wobei die Mikrolinsen-Schicht eine Linsen-Planarisierungsschicht (PLx, PLy), die mit der Farbfiltergruppe in Kontakt steht, und eine Mikrolinsen-Schicht (MLxa, MLya) auf der Linsenplanarisierungsschicht,
**dadurch gekennzeichnet, dass** die oberste Planarisierungsschicht einen oberen vertieften Abschnitt (57xa, 57ya) und einen Vertiefungsmittelpunkt (57xaCP, 57yaCP) sowohl im zentralen Pixelbereich als auch im Randpixelbereich aufweist, wobei der obere vertiefte Abschnitt in Richtung des Halbleitersubstrats vertieft ist und der Vertiefungsmittelpunkt in einem untersten Abschnitt des oberen vertieften Abschnitts definiert ist,
wobei im zentralen Pixelbereich ein Mittelpunkt (FSxaCP) einer freiliegenden flachen Oberseite der Linsenplanarisierungsschicht zumindest teilweise vertikal mit dem Vertiefungsmittelpunkt überlappt, und wobei sich im Randpixelbereich ein Mittelpunkt (FSyaCP) der flachen Oberseite auf einer vertikalen Linie befindet, die sich von der des Vertiefungsmittelpunkts unterscheidet.

2. Der Bildsensor nach Anspruch 1, wobei eine Innenfläche des oberen vertieften Abschnitts einen gekrümmt abgerundeten Abschnitt aufweist, und
wobei sich eine Krümmung des oberen vertieften Abschnitts im zentralen Pixelbereich von einer Krümmung des oberen vertieften Abschnitts im Randpixelbereich unterscheidet.

3. Der Bildsensor nach Anspruch 1, wobei der obere vertiefte Abschnitt eine geneigte Seitenfläche aufweist, die unter einem Winkel geneigt ist, und
wobei die Breite des oberen vertieften Abschnitts mit abnehmendem Abstand zum Halbleitersubstrat abnimmt.

4. Der Bildsensor nach Anspruch 1, wobei sich die Breite des oberen vertieften Abschnitts mit konstanter Änderungsrate verringert, und
wobei die Breite eines obersten Endes des oberen vertieften Abschnitts im zentralen Pixelbereich kleiner ist als die Breite des oberen vertieften Abschnitts im Randpixelbereich.

5. Der Bildsensor nach Anspruch 1, ferner umfassend:
eine Mehrzahl von photoelektrischen Umwandlungselementen, die jeweils der Farbfiltergruppe entsprechen,
wobei sich die Mikrolinse zumindest teilweise mit mindestens vier der Mehrzahl von photoelektrischen Umwandlungselementen überlappt.

6. Der Bildsensor nach Anspruch 1, wobei die Mikrolinse einen Linsenmittelpunkt aufweist, der in einem obersten Abschnitt der Mikrolinse definiert ist, und
wobei ein erster vertikaler Abstand von der ersten Oberfläche des Halbleitersubstrats zum Mittelpunkt der Aussparung kleiner ist als ein zweiter vertikaler Abstand von der ersten Oberfläche des Halbleitersubstrats zum Linsenmittelpunkt.

7. Der Bildsensor nach Anspruch 1, wobei die Mikrolinse der Mikrolinsen-Schicht eine Mehrzahl von Mikrolinsen umfasst, die voneinander beabstandet sind, und
wobei die Mehrzahl von Mikrolinsen Oberseiten aufweist, die in direktem Kontakt mit der obersten Planarisierungsschicht stehen.

8. Der Bildsensor nach Anspruch 1, ferner umfassend:
eine Mehrzahl von photoelektrischen Umwandlungselementen, die jeweils der Farbfiltergruppe entsprechen, und
ein tiefes Bauelement-Isolationsmuster, das die Mehrzahl von photoelektrischen Umwandlungselementen definiert,
wobei im zentralen Pixelbereich der Vertiefungsmittelpunkt des oberen vertieften Abschnitts zumindest teilweise mit dem tiefen Bauelement-Isolationsmuster überlappt, und
wobei im Randpixelbereich der Vertiefungsmittelpunkt des oberen vertieften Abschnitts gegenüber dem tiefen Bauelement-Isolationsmuster versetzt ist.

9. Der Bildsensor nach Anspruch 1, wobei ein Brechungsindex der obersten Planarisierungsschicht niedriger ist als ein Brechungsindex der Mikrolinsen-Schicht, und
wobei der Brechungsindex der obersten Planarisierungsschicht höher ist als ein Brechungsindex von Luft.

10. Ein Bildsensor, umfassend:
ein Halbleitersubstrat (100) mit einer ersten Oberfläche, einer der ersten Oberfläche gegenüberliegenden zweiten Oberfläche und einem Pixelarray-Bereich (R1), wobei der Pixelarray-Bereich einen zentralen Pixelbereich (X) und einen Randpixelbereich (Y) umfasst, der den zentralen Pixelbereich in der Draufsicht zumindest teilweise umschließt;
eine Farbfiltergruppe, die einen zentralen Farbfilter (CFx) auf dem zentralen Pixelbereich, einen Randfarbfilter (CFy) auf dem Randpixelbereich und eine Mehrzahl von Farbfiltern umfasst; und
eine Mikrolinsen-Schicht (MLLx, MLLy), die die Farbfiltergruppe zumindest teilweise bedeckt;
**gekennzeichnet durch** eine oberste Planarisierungsschicht (TLxa, TLya) auf der Mikrolinsen-Schicht (MLLx, MLLy),
wobei die Mikrolinsen-Schicht eine Linsenplanarisierungsschicht (PLxa, PLya) in Kontakt mit der Farbfiltergruppe und eine Mikrolinse (MLxa, MLya) auf der Linsenplanarisierungsschicht umfasst,
wobei die oberste Planarisierungsschicht einen oberen vertieften Abschnitt (57xa, 57ya) und einen Vertiefungsmittelpunkt (57xaCP, 57yaCP) sowohl im zentralen Pixelbereich (X) als auch im Randpixelbereich (Y) aufweist, wobei der obere vertiefte Abschnitt in Richtung des Halbleitersubstrats vertieft ist und der Vertiefungsmittelpunkt in einem untersten Abschnitt des oberen vertieften Abschnitts definiert ist,
wobei die Mikrolinse einen Linsenmittelpunkt (MLxaTP, MLyaTP), der in einem obersten Abschnitt der Mikrolinse definiert ist, und
wobei ein erster vertikaler Abstand (L1) von der ersten Oberfläche zum Vertiefungsmittelpunkt kleiner ist als ein zweiter vertikaler Abstand (L2) von der ersten Oberfläche zum Linsenmittelpunkt.

11. Der Bildsensor nach Anspruch 10, wobei im zentralen Pixelbereich ein Mittelpunkt einer freiliegenden, flachen Oberseite der Linsenplanarisierungsschicht zumindest teilweise vertikal mit dem Mittelpunkt der Aussparung überlappt, und
wobei im Randpixelbereich ein Mittelpunkt der flachen Oberseite auf einer vertikalen Linie liegt, die sich von der des Mittelpunkts der Aussparung unterscheidet.

12. Der Bildsensor nach Anspruch 10, ferner umfassend:
eine Gitterstruktur, die zwischen den Farbfiltern der Farbfiltergruppe angeordnet ist,
wobei sich die Gitterstruktur im zentralen Pixelbereich zumindest teilweise mit einer flachen Oberseite der Linsenplanarisierungsschicht und dem oberen vertieften Abschnitt überlappt,
wobei sich die Gitterstruktur im Randpixelbereich zumindest teilweise mit der Mikrolinse überlappt, und
wobei die flache Oberseite eine zumindest teilweise freiliegende Oberseite der Linsenplanarisierungsschicht umfasst.

13. Der Bildsensor nach Anspruch 10, ferner umfassend:
eine Mehrzahl von photoelektrischen Umwandlungselementen, die jeweils der Farbfiltergruppe entsprechen; sowie
ein tiefes Bauelement-Isolationsmuster, das die Mehrzahl von photoelektrischen Umwandlungselementen definiert,
wobei sich das tiefe Bauelement-Isolationsmuster im zentralen Pixelbereich zumindest teilweise mit einer freiliegenden, flachen Oberseite der Linsenplanarisierungsschicht und dem oberen vertieften Abschnitt überlappt, und
wobei sich das tiefe Bauelement-Isolationsmuster im Randpixelbereich zumindest teilweise mit dem Randfarbfilter und der Mikrolinse überlappt.

14. Der Bildsensor nach Anspruch 10, wobei der obere vertiefte Abschnitt eine geneigte Seitenfläche aufweist, die unter einem Winkel geneigt ist, und
wobei die Breite des oberen vertieften Abschnitts mit abnehmendem Abstand zum Halbleitersubstrat abnimmt.

15. Der Bildsensor nach Anspruch 14, wobei die Breite des obersten Abschnitts des oberen vertieften Abschnitts im zentralen Pixelbereich kleiner ist als die Breite des obersten Abschnitts des oberen vertieften Abschnitts im Randpixelbereich.

## Revendications

1. Un capteur d'image, comprenant :
un substrat semi-conducteur (100) comprenant une première surface, une deuxième surface opposée à la première surface, et une région de matrice de pixels (R1), la région de matrice de pixels comprenant une région de pixels centrale (X) et une région de pixels périphérique (Y) entourant au moins partiellement la région de pixels centrale en vue en plan ;
un groupe de filtres de couleur comprenant un filtre de couleur central (CFx) sur la région de pixels centrale, un filtre de couleur périphérique (CFy) sur la région de pixels périphérique, et une pluralité de filtres de couleur ;
une couche de microlentilles (MLLxa, MLLya) recouvrant au moins partiellement le groupe de filtres de couleur ; et
une couche de planarisation supérieure (TLxa, TLya) en contact avec une surface supérieure de la couche de microlentilles,
dans lequel la couche de microlentilles comprend une couche de planarisation de lentilles (PLx, PLy) en contact avec le groupe de filtres de couleur et des microlentilles (MLxa, MLya) sur la couche de planarisation de lentilles,
**caractérisée en ce que** la couche de planarisation supérieure comprend une partie en retrait supérieure (57xa, 57ya) et un point central de retrait (57xaCP, 57yaCP) dans chacune des régions de pixels centrales et périphériques, la partie en retrait supérieure étant en retrait vers le substrat semi-conducteur, et le point central du retrait étant défini dans une partie la plus basse de la partie en retrait supérieure,
dans lequel, dans la région de pixels centrale, un point central (FSxaCP) d'une surface supérieure plane exposée de la couche de planarisation de lentilles se superpose au moins partiellement verticalement au point central du retrait, et dans lequel, dans la région de pixels de bord, un point central (FSyaCP) de la surface supérieure plane est situé sur une ligne verticale différente de celle du point central de l'évidement.

2. Le capteur d'image selon la revendication 1, dans lequel une surface intérieure de la partie en retrait supérieure comprend une partie arrondie de manière courbe, et
dans lequel la courbure de la partie en retrait supérieure dans la région centrale des pixels est différente de la courbure de la partie en retrait supérieure dans la région périphérique des pixels.

3. Le capteur d'image selon la revendication 1, dans lequel la partie en retrait supérieure présente une surface latérale inclinée formant un certain angle, et
dans lequel la largeur de la partie en retrait supérieure diminue à mesure que la distance par rapport au substrat semi-conducteur diminue.

4. Le capteur d'image selon la revendication 1, dans lequel la largeur de la partie en retrait supérieure diminue à un taux de variation constant, et
dans lequel la largeur de l'extrémité la plus haute de la partie en retrait supérieure dans la région centrale des pixels est inférieure à la largeur de la partie en retrait supérieure dans la région périphérique des pixels.

5. Le capteur d'image selon la revendication 1, comprenant en outre :
une pluralité d'éléments de conversion photoélectrique correspondant respectivement au groupe de filtres de couleur,
dans lequel la microlentille recouvre au moins partiellement au moins quatre des éléments de conversion photoélectrique de ladite pluralité.

6. Le capteur d'image selon la revendication 1, dans lequel la microlentille comprend un point central de lentille défini dans une partie la plus supérieure de la microlentille, et
dans lequel une première distance verticale entre la première surface du substrat semi-conducteur et le point central de l'évidement est inférieure à une deuxième distance verticale entre la première surface du substrat semi-conducteur et le point central de la lentille.

7. Le capteur d'image selon la revendication 1, dans lequel la microlentille de la couche de microlentilles comprend une pluralité de microlentilles, qui sont espacées les unes des autres, et
dans lequel la pluralité de microlentilles présente des surfaces supérieures qui sont en contact direct avec la couche de planarisation la plus supérieure.

8. Le capteur d'image selon la revendication 1, comprenant en outre :
une pluralité d'éléments de conversion photoélectrique correspondant respectivement au groupe de filtres de couleur, et
un motif d'isolation profonde des dispositifs définissant la pluralité d'éléments de conversion photoélectrique,
dans lequel, dans la région de pixels centrale, le point central de l'évidement de la partie évidée supérieure chevauche au moins partiellement le motif d'isolation profonde des dispositifs, et
dans lequel, dans la région de pixels périphérique, le point central de l'évidement de la partie évidée supérieure est désaligné par rapport au motif d'isolation profonde des dispositifs.

9. Le capteur d'image selon la revendication 1, dans lequel l'indice de réfraction de la couche de planarisation la plus supérieure est inférieur à l'indice de réfraction de la couche de microlentilles, et
dans lequel l'indice de réfraction de la couche de planarisation la plus supérieure est supérieur à l'indice de réfraction de l'air.

10. Un capteur d'image, comprenant :
un substrat semi-conducteur (100) comprenant une première surface, une deuxième surface opposée à la première surface, et une région de matrice de pixels (R1), la région de matrice de pixels comprenant une région de pixels centrale (X) et une région de pixels périphérique (Y) entourant au moins partiellement la région de pixels centrale en vue en plan ;
un groupe de filtres de couleur comprenant un filtre de couleur central (CFx) sur la région de pixels centrale, un filtre de couleur périphérique (CFy) sur la région de pixels périphérique, et une pluralité de filtres de couleur ; et
une couche de microlentilles (MLLx, MLLy) recouvrant au moins partiellement le groupe de filtres de couleur ;
**caractérisé par** une couche de planarisation supérieure (TLxa, TLya) sur la couche de microlentilles (MLLx, MLLy),
dans lequel la couche de microlentilles comprend une couche de planarisation de lentilles (PLxa, PLya) en contact avec le groupe de filtres de couleur et une microlentille (MLxa, MLya) sur la couche de planarisation de lentilles,
dans lequel la couche de planarisation supérieure comprend une partie en retrait supérieure (57xa, 57ya) et un point central de retrait (57xaCP, 57yaCP) dans chacune de la région de pixels centrale (X) et de la région de pixels périphérique (Y), la partie supérieure en retrait étant en retrait vers le substrat semi-conducteur, et le point central d'évidement étant défini dans une partie la plus basse de la partie supérieure en retrait,
dans lequel la microlentille comprend un point central de lentille (MLxaTP, MLyaTP) défini dans une partie la plus haute de la microlentille, et
dans lequel une première distance verticale (L1) entre la première surface et le point central de l'évidement est inférieure à une deuxième distance verticale (L2) entre la première surface et le point central de la lentille.

11. Le capteur d'image selon la revendication 10, dans lequel, dans la région de pixels centrale, un point central d'une surface supérieure plane exposée de la couche de planarisation de la lentille se superpose au moins partiellement, verticalement, au point central de l'évidement, et
dans lequel, dans la région de pixels périphérique, un point central de la surface supérieure plane est situé sur une ligne verticale différente de celle du point central de l'évidement.

12. Le capteur d'image selon la revendication 10, comprenant en outre :
une structure en grille intercalée entre les filtres de couleur du groupe de filtres de couleur,
dans lequel, dans la région de pixels centrale, la structure en grille se superpose au moins partiellement à une surface supérieure plane de la couche de planarisation de lentille et à la partie en retrait supérieure,
dans lequel, dans la région de pixels périphérique, la structure en grille se superpose au moins partiellement à la microlentille, et
dans lequel la surface supérieure plane comprend une surface supérieure au moins partiellement exposée de la couche de planarisation de lentille.

13. Le capteur d'image selon la revendication 10, comprenant en outre :
une pluralité d'éléments de conversion photoélectrique correspondant respectivement au groupe de filtres de couleur ; et
un motif d'isolation en profondeur des dispositifs définissant ladite pluralité d'éléments de conversion photoélectrique,
dans lequel, dans la région des pixels centraux, le motif d'isolation en profondeur des dispositifs recouvre au moins partiellement une surface supérieure plane exposée de la couche de planarisation de la lentille et la partie en retrait supérieure, et
dans lequel, dans la région des pixels périphériques, le motif d'isolation en profondeur des dispositifs recouvre au moins partiellement le filtre de couleur périphérique et la microlentille.

14. Le capteur d'image selon la revendication 10, dans lequel la partie en retrait supérieure présente une surface latérale inclinée formant un certain angle, et
dans lequel la largeur de la partie en retrait supérieure diminue à mesure que la distance par rapport au substrat semi-conducteur diminue.

15. Le capteur d'image selon la revendication 14, dans lequel la largeur de la partie la plus haute de la partie en retrait supérieure dans la région des pixels centraux est inférieure à la largeur de la partie la plus haute de la partie en retrait supérieure dans la région des pixels périphériques.
